(19) Europäisches Patentamt
European Patent Office
Office européen des brevets

(11) **EP 4 568 149 A1**

(12) **EUROPEAN PATENT APPLICATION**
published in accordance with Art. 153(4) EPC

(43) Date of publication:
**11.06.2025 Bulletin 2025/24**

(21) Application number: **23856284.7**

(22) Date of filing: **30.06.2023**

(51) International Patent Classification (IPC):
*H04L 1/00* *(2006.01)*

(52) Cooperative Patent Classification (CPC):
**H04L 1/00**

(86) International application number:
**PCT/CN2023/104371**

(87) International publication number:
**WO 2024/041194 (29.02.2024 Gazette 2024/09)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **25.08.2022 CN 202211026138**

(71) Applicant: **Huawei Technologies Co., Ltd.
Shenzhen, Guangdong 518129 (CN)**

(72) Inventors:
• **WANG, Hui**
  **Chengdu, Sichuan 611756 (CN)**
• **LIN, Wei**
  **Shenzhen, Guangdong 518129 (CN)**
• **LIU, Chenchen**
  **Shenzhen, Guangdong 518129 (CN)**
• **LEI, Xianfu**
  **Chengdu, Sichuan 611756 (CN)**
• **TANG, Xiaohu**
  **Chengdu, Sichuan 611756 (CN)**
• **GAN, Ming**
  **Shenzhen, Guangdong 518129 (CN)**
• **YANG, Xun**
  **Shenzhen, Guangdong 518129 (CN)**

(74) Representative: **Isarpatent
Patent- und Rechtsanwälte
Barth Hassa Peckmann & Partner mbB
Friedrichstraße 31
80801 München (DE)**

(54) **RATE MATCHING METHOD AND COMMUNICATION APPARATUS**

(57) This application provides a rate matching method and a communication apparatus. A transmit end punctures an LDPC codeword based on a priority order of check bits of a mother code of an LDPC code. The priority order of the check bits of the mother code indicates a priority order of puncturing the check bits in a rate matching process, and the priority order is related to confidences of the check bits. The confidences of the check bits indicate degrees to which the check bits are affected by noise in a channel transmission process. In addition, puncturing the check bits can ensure restorability of a system variable node, and a check bit with a higher confidence is more likely to be correctly restored, so that more valid information can be provided for another system variable node during decoding iteration. Therefore, in this application, it is considered that a check bit with a high confidence is preferentially punctured, to provide more valid information for another system variable node in an iterative decoding process, thereby improving decoding performance of a receive end.

400

Perform rate matching on a first LDPC codeword with a first code rate based on a priority order of check bits of a mother code of an LDPC code, to obtain a second LDPC codeword with a second code rate, where the priority order indicates a priority order of puncturing the check bits of the mother code during rate matching, the priority order is related to confidences of the check bits, and the confidences of the check bits indicate degrees to which the check bits are affected by noise in a channel transmission process — 410

Send the second LDPC codeword — 420

FIG. 4

## Description

This application claims priority to Chinese Patent Application No. 202211026138.X, filed with the China National Intellectual Property Administration on August 25, 2022 and entitled "RATE MATCHING METHOD AND COMMUNICATION APPARATUS", which is incorporated herein by reference in its entirety.

## TECHNICAL FIELD

This application relates to the field of channel coding, and more specifically, to an LDPC rate matching method and a communication apparatus.

## BACKGROUND

In the field of channel coding, a low-density parity-check (low-density parity-check, LDPC) code is a most mature and widely applied channel coding scheme. The LDPC code has performance close to the Shannon limit, and has many advantages. Therefore, protocols such as IEEE 802.11n, 802.11ac, and 802.11ax propose that the LDPC code be used as a standard channel coding scheme for a wireless local area network (wireless local area network, WLAN). Currently, a total of 12 check matrices of the LDPC code are used in the 802.11ac/ax standard. There are three code lengths, and each code length supports four code rates. A transmit-end device selects a corresponding check matrix from the 12 check matrices based on a target code length and code rate, to perform LDPC encoding.

To further improve a throughput of a communication system, it is proposed in a next-generation WLAN 802.11be standard that an incremental redundancy-hybrid automatic repeat request (incremental redundancy-hybrid automatic repeat request, IR-HARQ) mechanism is introduced based on the 802.11ax standard. The IR-HARQ mechanism expects to increase a redundant bit through retransmission and reduce a channel coding rate, to improve decoding performance of a receive end.

However, the foregoing coding scheme used in the current WLAN standard cannot meet a requirement of continuously increasing redundant bits through retransmission in the IR-HARQ mechanism to reduce a channel coding rate and improve decoding performance.

## SUMMARY

This application provides a rate matching method and a communication apparatus, which can improve decoding performance.

According to a first aspect, this application provides a rate matching method. The method includes: A transmit end performs rate matching on a first LDPC codeword with a first code rate based on a priority order of check bits of a mother code of an LDPC code, to obtain a second LDPC codeword with a second code rate. The priority order indicates a priority order of puncturing the check bits of the mother code during rate matching, the priority order is related to confidences of the check bits, and the confidences of the check bits indicate a degree to which the check bits are affected by noise in a channel transmission process. The transmit end sends the second LDPC codeword.

In the technical solutions of this application, the transmit end performs rate matching on an LDPC codeword based on the priority order of puncturing the check bits of the mother code of the LDPC code during rate matching. The priority order of the check bits indicates a priority order of puncturing the check bits in a rate matching process, the priority order is related to the confidences of the check bits, and the confidences of the check bits indicate degrees to which the check bits are affected by noise in a channel transmission process. The confidences of the check bits reflect reliability of the check bits. In addition, puncturing the check bits can ensure restorability of a system variable node, and a check bit with a higher confidence is more likely to be correctly restored, so that more valid information can be provided for another system variable node during decoding iteration. Therefore, when the priority order of the check bits in the rate matching process (specifically, a priority order of puncturing bits) is designed, it may be considered that a check bit with a high confidence is preferentially punctured, to provide more valid information for another system variable node in an iterative decoding process, thereby improving decoding performance.

In addition, the transmit end punctures an LDPC codeword with a low code rate based on the priority order of the check bits of the mother code of the LDPC code, to obtain an LDPC codeword that is compatible with the low code rate and that has a higher code rate. Alternatively, the transmit end may obtain an LDPC codeword with a low code rate based on the priority order of the check bits of the mother code and a puncturing position of an LDPC codeword with a high code rate. Therefore, the technical solutions of this application are also applicable to an enhanced link adaptation scenario. Two communication parties may select an appropriate code rate for communication based on a link status, to select a code rate at a finer granularity.

With reference to the first aspect, in some implementations of the first aspect, that a transmit end performs rate matching on a first LDPC codeword with a first code rate based on a priority order of check bits of a mother code includes: The transmit end selects, based on a quantity L of to-be-punctured bits and the priority order of the check bits of the mother code, L check bits in the first LDPC codeword for puncturing. The priority order is a descending order of the confidences of the check bits, and the L check bits are the first L check bits in the priority order. $L \geq 1$, and L is an integer.

It should be understood that priorities of the L check bits are all higher than priorities of other check bits in the check bits included in the mother code.

With reference to the first aspect, in some implementations of the first aspect, a check matrix of the mother code includes a check part, the check part includes a column that corresponds to a check bit and that is in the check matrix of the mother code, and the priority order indicates a priority order of columns included in the check part. Each of the columns included in the check part corresponds to z check bits of the mother code, $z = N/n$, N is a code length of the mother code, and n represents a total quantity of columns included in the check matrix of the mother code.

With reference to the first aspect, in some implementations of the first aspect, the code length of the mother code is 1944, a code rate is 1/2, the check part is a 13th column to a 24th column in the check matrix of the mother code, and a descending order of priorities of the 13th column to the 24th column is as follows:

13, 14, 24, 15, 23, 16, 22, 17, 21, 18, 20, 19.

With reference to the first aspect, in some implementations of the first aspect, the code length of the mother code is 1296, a code rate is 1/2, the check part is a 13th column to a 24th column in the check matrix of the mother code, and a descending order of priorities of the 13th column to the 24th column is as follows:

13, 17, 22, 18, 24, 16, 23, 19, 14, 21, 15, 20.

With reference to the first aspect, in some implementations of the first aspect, the code length of the mother code is 648, a code rate is 1/2, the check part is a 13th column to a 24th column in the check matrix of the mother code, and a descending order of priorities of the 13th column to the 24th column is as follows:

13, 17, 16, 20, 24, 14, 19, 18, 23, 22, 15, 21.

In the foregoing embodiments, a column index of the check matrix of the mother code is sequentially numbered from 1. For example, for the mother code whose code rate is 1/2 and whose code length is 1944, 1296, or 648, a column index range of the check matrix of the mother code is [1, 24].

Optionally, in some embodiments, a column index of the check matrix of the mother code may alternatively be sequentially numbered from 0. In this case, for the mother code whose code rate is 1/2 and whose code length is 1944, 1296, or 648 in this embodiment of this application, a column index range of the check matrix of the mother code is [0, 23].

It should be understood that the technical solutions expressed by the foregoing two different index ranges, namely, [1, 24] and [0, 23], are essentially the same.

With reference to the first aspect, in some implementations of the first aspect, priorities of z check bits corresponding to any one of the columns included in the check part of the check matrix of the mother code are the same.

With reference to the first aspect, in some implementations of the first aspect, the L check bits in the first LDPC codeword meet one of the following features:

if $L < z$, the L check bits in the first LDPC codeword are L check bits in z check bits corresponding to a highest-priority column in the columns included in the check part, where z is a positive integer; or

if $L > z$, the L check bits in the first LDPC codeword are L check bits in tz check bits corresponding to t columns in the columns included in the check part, where the L check bits include z(t-1) check bits corresponding to the first t-1 columns in the t columns and p check bits in a tth column, the p check bits are any p check bits in z check bits corresponding to the tth column, both t and p are positive integers, and $p \leq z$; or

if $L = mz$, the L check bits in the first LDPC codeword are mz check bits corresponding to m columns in the columns included in the check part, where the m columns are the first m columns in the columns included in the check part that are sorted in descending order of priorities, $m \geq 1$, and m is an integer.

It should be noted that, in some descriptions of this embodiment of this application, "Q columns corresponding to highest priorities in the check matrix of the mother code" represents that in all columns of the check matrix of the mother code, a priority of a lowest-priority column in the Q columns is higher than a priority of a highest-priority column in remaining columns other than the Q columns in the check matrix.

For example, assuming that the code rate of the mother code is 1/2 and the code length is 1944, the check matrix of the mother code includes 24 columns (refer to the specification). Columns corresponding to the check bits are the 13th column to the 24th column (namely, the check part). Assuming that the priority order of the 13th column to the 24th column is 13, 14, 24, 15, 23, 16, 22, 17, 21, 18, 20, 19 in descending order of priorities, four columns (for example, Q = 4) with highest priorities are the 13th column, the 14th column, the 24th column, and the 15th column.

With reference to the first aspect, in some implementations of the first aspect, after the transmit end sends the second LDPC codeword, the method further includes: The transmit end receives retransmission indication information. The transmit end performs rate matching on a to-be-retransmitted codeword based on the priority order of the check bits of the mother code, to obtain a third LDPC codeword with a third code rate. The to-be-retransmitted codeword is obtained by performing LDPC encoding on to-be-retransmitted bits, and a puncturing position set of check bits of the third LDPC codeword is a proper subset of a puncturing position set of check bits of the second LDPC codeword. The transmit end sends the third LDPC codeword.

According to a second aspect, this application provides a decoding method. The method includes: A receive end receives a first channel receiving sequence. The receive end pads, with zeros based on a priority order of check bits of a mother code of an LDPC code, corresponding positions of a first LLR sequence corresponding to the first channel receiving sequence, and decodes the first LLR sequence that is padded with zeros. The corresponding positions of the first LLR sequence are positions of check bits punctured in a rate matching process of an LDPC codeword corresponding to the first channel receiving sequence, the priority order of the check bits is related to confidences of the check bits, and the confidences of the check bits indicate degrees to which the check bits are affected by noise in a channel transmission process. The receive end requests a transmit end to perform retransmission if a system bit of the LDPC codeword fails to be obtained through decoding.

It may be understood that, when the receive end successfully decodes the system bit of the LDPC codeword, the receive end outputs a decoding result.

With reference to the second aspect, in some implementations of the second aspect, the check bits punctured in the rate matching process of the LDPC codeword are the first $L$ check bits that are in the check bits of the mother code corresponding to the LDPC codeword and that are sorted in descending order of priorities. $L$ is a quantity of to-be-punctured check bits, and $L$ is an integer.

With reference to the second aspect, in some implementations of the second aspect, a check matrix of the mother code includes a check part, the check part includes a column that corresponds to a check bit and that is in the check matrix, and the priority order indicates a priority order of columns included in the check part. Each of the columns included in the check part corresponds to $z$ codeword bits of the mother code, $z = N/n$, $N$ represents a code length of the mother code, $n$ represents a total quantity of columns included in the check matrix of the mother code, and $N$ and $n$ are integers.

With reference to the second aspect, in some implementations of the second aspect, a length of the mother code is 1944, a code rate is 1/2, the check part is a $13^{th}$ column to a $24^{th}$ column in the check matrix of the mother code, and a descending order of priorities of the $13^{th}$ column to the $24^{th}$ column is as follows:
13, 14, 24, 15, 23, 16, 22, 17, 21, 18, 20, 19.

With reference to the second aspect, in some implementations of the second aspect, a length of the mother code is 1296, a code rate is 1/2, the check part is a $13^{th}$ column to a $24^{th}$ column in the check matrix of the mother code, and a descending order of priorities of the $13^{th}$ column to the $24^{th}$ column is as follows:
13, 17, 22, 18, 24, 16, 23, 19, 14, 21, 15, 20.

With reference to the second aspect, in some implementations of the second aspect, a length of the mother code is 648, a code rate is 1/2, the check part is a $13^{th}$ column to a $24^{th}$ column in the check matrix of the mother code, and a descending order of priorities of the $13^{th}$ column to the $24^{th}$ column is as follows:
13, 17, 16, 20, 24, 14, 19, 18, 23, 22, 15, 21.

With reference to the second aspect, in some implementations of the second aspect, priorities of $z$ codeword bits corresponding to any column included in the check part are the same.

With reference to the second aspect, in some implementations of the second aspect, the $L$ check bits punctured in the rate matching process of the LDPC codeword corresponding to the first channel receiving sequence meet one of the following cases:

if $L < z$, the $L$ punctured check bits are any $L$ check bits in $z$ check bits corresponding to a highest-priority column in the columns included in the check part; or

if $L > z$, the $L$ punctured check bits are $L$ check bits in $tz$ check bits corresponding to $t$ columns in the columns included in the check part, where the $t$ columns are the first $t$ columns in the columns included in the check part that are sorted in descending order of priorities, the $L$ check bits include $z(t-1)$ check bits corresponding to the first $t-1$ columns in the $t$ columns and $p$ check bits in a $t^{th}$ column, the $p$ check bits are any $p$ check bits in $z$ check bits corresponding to the $t^{th}$ column, both $t$ and $p$ are positive integers, and $p \leq z$; or

if $L = mz$, the $L$ punctured check bits are $mz$ check bits corresponding to $m$ columns included in the check part, where the $m$ columns are the first $m$ columns in the columns included in the check part that are sorted in descending order of priorities.

With reference to the second aspect, in some implementations of the second aspect, that the receive end requests a transmit end to perform retransmission if a system bit of the LDPC codeword corresponding to the first channel receiving sequence fails to be obtained through decoding includes:

the receive end sends retransmission indication information to the transmit end;

the receive end receives a second channel receiving sequence; and

the receive end pads, with zeros based on the priority order of the check bits of the LDPC code, corresponding positions of a second LLR sequence corresponding to the second channel receiving sequence, and decodes a combined sequence of the second LLR sequence that is padded with zeros and the first LLR sequence that is padded with zeros. A set including positions that need to be padded with zeros in the second LLR sequence is a proper subset of a set including positions that need to be padded with zeros in the first LLR sequence. The positions that need to be padded with zeros in the second LLR sequence are the first several positions in the positions that need to be padded with zeros in the first LLR sequence and that are sorted in descending order of priorities.

It should be noted that, that the positions that need to be padded with zeros in the second LLR sequence are the first several positions in the positions that need to be padded with zeros in the first LLR sequence and that are sorted in descending order of priorities indicates that a set of the positions that need to be padded with zeros in the first LLR sequence completely includes a set of the positions that need to be padded with zeros in the second LLR sequence, and the positions that need to be padded with zeros in the second LLR sequence are the first several positions in the positions that need to be padded with zeros in the first LLR sequence and that are sorted in descending order.

For example, a set 1 of the positions that need to be padded with zeros in the first LLR sequence is $\{n_1, n_2, ..., n_T\}$. Assuming that the positions in the set 1 are arranged in descending order of priorities, the positions that need to be padded with zeros in the second LLR sequence may be several positions in the set $1\{n_1, n_2, ..., n_T\}$ in a front-to-back order. For example, if there are two positions that need to be padded with zeros in the second LLR sequence, the positions that need to be padded with zeros in the second LLR sequence are $n_1$ and $n_2$. For another example, if there are four positions that need to be padded with zeros in the second LLR sequence, the positions that need to be padded with zeros in the second LLR sequence are $n_1$, $n_2$, $n_3$, and $n_4$.

According to a third aspect, this application provides a communication apparatus. The communication apparatus has a function of implementing the method according to the first aspect or any possible implementation of the first aspect. The function may be implemented by hardware, or may be implemented by hardware executing corresponding software. The hardware or the software includes one or more units corresponding to the foregoing function.

According to a fourth aspect, this application provides a communication apparatus. The communication apparatus has a function of implementing the method according to the second aspect or any possible implementation of the second aspect. The function may be implemented by hardware, or may be implemented by hardware executing corresponding software. The hardware or the software includes one or more units corresponding to the foregoing function.

According to a fifth aspect, this application provides a communication apparatus, including an interface circuit and a processor. The interface circuit is configured to receive computer code or instructions, and transmit the computer code or the instructions to the processor. The processor runs the computer code or the instructions, to implement the method according to the first aspect or any implementation of the first aspect.

According to a sixth aspect, this application provides a communication apparatus, including an interface circuit and a processor. The interface circuit is configured to receive computer code or instructions, and transmit the computer code or the instructions to the processor. The processor runs the computer code or the instructions, to implement the method according to the second aspect or any implementation of the second aspect.

According to a seventh aspect, this application provides a communication device, including at least one processor. The at least one processor is coupled to at least one memory. The at least one memory is configured to store a computer program or instructions. The at least one processor is configured to invoke, from the at least one memory, and run the computer program or the instructions, to enable the communication device to perform the method according to the first aspect or any possible implementation of the first aspect.

In an example, the communication device may be an encoder.

According to an eighth aspect, this application provides a communication device, including at least one processor. The at least one processor is coupled to at least one memory. The at least one memory is configured to store a computer program or instructions. The at least one processor is configured to invoke, from the at least one memory, and run the computer program or the instructions, to enable the communication device to perform the method according to the second aspect or any possible implementation of the second aspect.

In an example, the communication device may be a decoder (also referred to as a decipherer).

According to a ninth aspect, this application provides a computer-readable storage medium. The computer-readable storage medium stores computer instructions. When the computer instructions are run on a computer, the method according to the first aspect, the second aspect, or any possible implementation of the first aspect or the second aspect is implemented.

According to a tenth aspect, this application provides a computer program product. The computer program product includes computer program code. When the computer program code is run on a computer, the method according to the first aspect, the second aspect, or any possible implementation of the first aspect or the second aspect is implemented.

According to an eleventh aspect, this application provides a wireless communication system, including the communication apparatus according to the third aspect and the communication apparatus according to the fourth aspect, for example, the transmit end and the receive end (namely, the encoder and the decoder) in embodiments of this application.

## BRIEF DESCRIPTION OF DRAWINGS

FIG. 1 is a diagram of a check matrix H of an LDPC code;
FIG. 2 is a Tanner graph of a check matrix H of an LDPC code;
(a) and (b) in FIG. 3 are diagrams of system architectures applicable to an embodiment of this application;
FIG. 4 is a schematic flowchart of a rate matching method according to this application;
FIG. 5 is a diagram of a rate matching process of an LDPC code according to this application;
FIG. 6 is a diagram of a decoding process at a receive end according to this application;
FIG. 7 is a flowchart of obtaining a confidence order of check bits according to this application;
FIG. 8 shows an image of a function $\varphi(x)$ used to determine a confidence order of check bits according to an embodiment of this application;
FIG. 9 shows an application example of a rate matching method according to this application;
FIG. 10 to FIG. 19 show comparison between BER performance curves of a confidence-based puncturing scheme provided in this application and a conventional puncturing scheme for various quantities of to-be-punctured check bits;
FIG. 20 is a block diagram of a communication apparatus 1000 according to this application; and
FIG. 21 is a diagram of a structure of a communication apparatus 10 according to this application.

## DESCRIPTION OF EMBODIMENTS

The following describes technical solutions of embodiments in this application with reference to accompanying drawings.

In the field of channel coding, a low-density parity-check (low-density parity-check, LDPC) code is a most mature and widely applied channel coding scheme. The LDPC code has performance close to the Shannon limit, and has many advantages, for example, having good bit error performance without deep interleaving, having good frame error rate performance, and a small decoding delay due to supporting of parallel decoding. Therefore, protocols such as IEEE 802.11n, 802.11ac, and 802.11ax propose that the LDPC code be used as a standard channel coding scheme for a wireless local area network (wireless local area network, WLAN).

In a next-generation wireless local area network (wireless local area network, WLAN) 802.11be standard of the 802.11ax standard, a hybrid automatic repeat request (hybrid automatic repeat request, HARQ) is proposed, to further improve a throughput rate of a system. The HARQ is mainly used for storage, requesting for retransmission, and combination and demodulation. When failing to perform data decoding (or decoding), a receive end stores received data and requests a transmit end to retransmit data. The receive end combines the retransmitted data and the previously received and stored data, and performs decoding. A success rate of data decoding can be improved by using a diversity gain.

The HARQ may generally include two types: chase combining (chase combine, CC) and incremental redundancy (incremental redundancy, IR), which may respectively be referred to as a CC HARQ and an IR HARQ.

The HARQ mechanism may include two types: chase combining (chase combine, CC) and incremental redundancy (incremental redundancy, IR-HARQ). In a HARQ-only mechanism, the receive end directly discards data packets that are incorrectly received. However, although the data packets that are incorrectly received cannot be correctly decoded independently, the data packets still include a part of useful information. This part of information is used in the CC HARQ, to store the data packets that are incorrectly received into a memory, and combine the data packets with a retransmitted data packet for decoding. This improves transmission efficiency. The IR HARQ mechanism means that the transmit end sends an information bit and some redundant bits during an initial transmission, and sends additional redundant bits during a retransmission. If correct decoding fails during the initial transmission, the transmit end retransmits more redundant bits to decrease a code rate of a channel, thereby increasing a decoding success rate. If the receive end still cannot correctly perform decoding based on redundant bits in a first retransmission, the transmit end performs retransmission again. As a quantity of retransmissions increases, redundant bits continuously increase, and a channel coding rate continuously decreases, thereby achieving better decoding effect.

If the IR HARQ mechanism is introduced into the next-generation WLAN standard, an LDPC encoding scheme supporting compatibility with a plurality of rates is required for support, so that a new incremental redundant bit can be introduced during a retransmission.

To facilitate understanding of the solutions of this application, a concept related to an LDPC code is first described.

The LDPC code is a linear block code, and a check matrix of the LDPC code is a sparse matrix. In the check matrix of the LDPC code, a quantity of zero elements is far greater than a quantity of non-zero elements. Alternatively, a row weight and a column weight of the check matrix are much less than a code length of the LDPC code. An LDPC code whose information bit sequence length is equal to k and whose code length is equal to n may be uniquely determined based on a check matrix of the LDPC code.

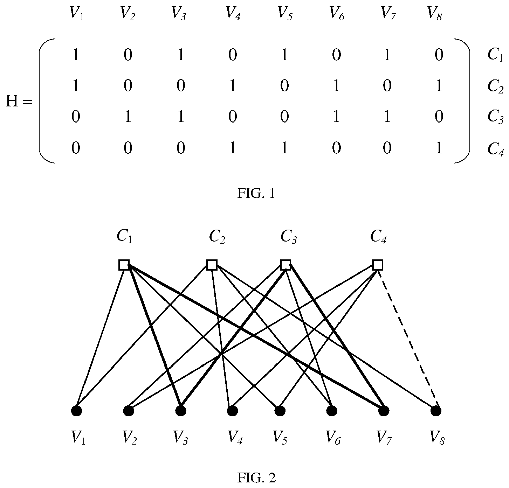

In 1981, Tanner represented a codeword of an LDPC code in a graph. This graph now is referred to as a Tanner graph, and the Tanner graph and the check matrix are in a one-to-one correspondence. The Tanner graph includes two types of vertices. One type of vertex indicates a codeword bit and is referred to as a variable node. The other type of vertex is a check node and indicates a check constraint relationship. Each check node indicates one check constraint relationship. The following provides description with reference to FIG. 1 and FIG. 2.

FIG. 1 is a diagram of a check matrix H of an LDPC code. In FIG. 1, $\{V_i\}$ indicates a variable node set, and $\{C_i\}$ indicates a check node set. In the check matrix H, each row indicates one check equation, and each column indicates one codeword bit. In FIG. 1, there are eight variable nodes and four check nodes. If a codeword bit is included in a corresponding check equation, related bit nodes and check nodes are connected by using a connection line, to obtain a Tanner graph.

FIG. 2 is a Tanner graph of a check matrix H of an LDPC code. As shown in FIG. 2, the Tanner graph indicates the check matrix of the LDPC code. For example, for the check matrix H with a size of m rows and n columns, the Tanner graph includes two types of nodes: n variable nodes and m check nodes. The n variable nodes respectively correspond to the n columns of the check matrix H, and the m check nodes respectively correspond to the m rows of the check matrix H. A cycle in the Tanner graph consists of connected vertices. The cycle uses one of the vertices as both a start point and an end point, and passes through each node only once. A length of the cycle is defined as a quantity of connection lines included in the cycle. A girth of a graph may also be referred to as a size of the graph, and is defined as a minimum cycle length in the graph. In FIG. 2, a girth is 6, as shown by a bold connection line in FIG. 2. The variable nodes in the Tanner graph each correspond to one column of the check matrix H, that is, correspond to each codeword bit of the LDPC code. The check nodes in the Tanner graph each correspond to one row of the check matrix H, that is, correspond to check bits of the LDPC code. Connection between the two types of nodes corresponds to a value of an element in the matrix H. If there is a connection between an $i^{th}$ check node and a $j^{th}$ variable node, it indicates that a value of an element (i, j) in the matrix H is 1. If there is no connection between an $i^{th}$ check node and a $j^{th}$ variable node, a corresponding element is 0.

In addition, in the Tanner graph, a cycle (cycle) is a closed loop formed by a variable node, a check node, and an edge that are connected end to end.

As described above, the LDPC code is a linear block code. In the linear block code, a to-be-encoded information sequence is divided into groups in a unit of k bits, and an encoder performs a linear operation on the k information bits to obtain m check bits. Then, the k information bits are combined with the m check bits to obtain a code group whose length is n = k + m. A mapping relationship between the information bits of k bits and the code group whose length is n bits is usually represented by a corresponding check matrix H. An encoding sequence may be correspondingly generated based on the check matrix H to complete an encoding process. After the encoding sequence is transmitted through a channel, the receive end correspondingly decodes a received signal, to determine an original information bit.

When the code length is long, the check matrix H of the LDPC code is very large. Therefore, the check matrix H is usually divided into blocks to indicate that a complete check matrix H is generated by using a plurality of submatrices of z×z. Specifically, the complete check matrix H may be represented by a base matrix $H_b$, each element in $H_b$ corresponds to a submatrix of z×z, and each submatrix may be represented by a quantity of cyclically shifted bits. Therefore, storage space required by the complete check matrix H is greatly reduced.

In this embodiment of this application, a check matrix in the 802.11ac standard is used, and code lengths 1944, 1296, and 648 are supported. The three code lengths all support a code rate of 1/2. Based on a base matrix $H_b$ and an expansion factor z that are provided in the 802.11ac standard, the base matrix may be expanded to a complete check matrix for encoding or decoding.

An LDPC code used in the IEEE 802.11ac standard and the 802.11ax standard is a quasi-cyclic low-density parity-check (quasi-cyclic low-density parity-check, QC-LDPC) code. The QC-LDPC code is a type of structured LDPC code. Due to a unique structure of a check matrix of the QC-LDPC code, a simple feedback shift register may be used during encoding, to reduce encoding complexity of the LDPC code.

In the IEEE 802.11ac standard and the 802.11ax standard, a total of 12 check matrices of the LDPC code are used, and three code lengths are supported. The three code lengths are respectively 648, 1296, and 1944. Each code length supports four code rates: 1/2, 2/3, 3/4, and 5/6. Check bit parts of the 12 check matrices all have a same structure.

For example, a check matrix H of the LDPC code with a code length of 1944 and a code rate of 5/6 in the 802.11 ac standard is shown as follows:

$$\begin{bmatrix} 13 & 48 & 80 & 66 & 4 & 74 & 7 & 30 & 76 & 52 & 37 & 60 & - & 49 & - & 73 & 31 & 74 & 73 & 23 & 1 & 0 & - & - \\ 69 & 63 & 74 & 56 & 64 & 77 & 57 & 65 & 6 & 16 & 51 & - & 64 & - & 64 & 68 & 9 & 48 & 62 & 54 & - & 0 & 0 & - \\ 51 & 15 & 0 & 80 & 24 & 25 & 42 & 54 & 44 & 71 & 71 & 9 & 67 & 35 & 67 & - & 58 & - & 29 & - & 0 & - & 0 & 0 \\ 16 & 29 & 36 & 41 & 44 & 56 & 59 & 37 & 50 & 24 & - & 65 & 4 & 65 & 4 & 52 & - & 4 & - & 73 & 1 & - & - & 0 \end{bmatrix}$$

It can be learned that a size of the check matrix H is 4 rows and 24 columns, each element in the check matrix represents a z=N/24-order square matrix, an element 0 in the matrix represents an all-zero square matrix with a size of z × z, an element $P_z^i$ represents a circulant permutation matrix, and i represents a cyclic shift value. $0 \leq i \leq z - 1$, and i is an integer. In addition, "-" in the matrix represents an all-zero matrix, and "0" represents an identity matrix.

For example, $P_z^1$ is shown as follows:

$$P_z^1 = \begin{bmatrix} 0 & 1 & 0 & \cdots & 0 \\ 0 & 0 & 1 & \cdots & 0 \\ \vdots & \vdots & \vdots & \ddots & \vdots \\ 0 & 0 & 0 & \cdots & 1 \\ 1 & 0 & 0 & \cdots & 0 \end{bmatrix}$$

When LDPC code encoding in the WLAN is performed, the transmit end selects a corresponding check matrix from the 12 check matrices based on a target code length and a target code rate. The 12 check matrices are different from each other.

To improve WLAN transmission reliability, an IR-HARQ mechanism is introduced into the IEEE 802.11be standard based on the previous 802.11ax standard. For the IR-HARQ mechanism, to obtain a higher throughput, a rate-compatible LDPC code needs to be introduced into the WLAN, to obtain incremental redundant bits during retransmission. In this way, the receive end obtains performance gains by combining initially received bits and retransmitted incremental redundant bits.

The following describes the technical solutions of this application with reference to the accompanying drawings.

The technical solutions of this application may be applied to various wireless communication systems, including but not limited to: a 5th generation (the 5th generation, 5G) system or a new radio (new radio, NR) system, a long term evolution (long term evolution, LTE) system, a long term evolution-advanced technology (long term evolution-advanced, LTE-A) system, an LTE frequency division duplex (frequency division duplex, FDD) system, an LTE time division duplex (time division duplex, TDD) system, and the like. The technical solutions may be further applied to a future communication system, for example, a 6th generation mobile communication system. In addition, the technical solutions may be further applied to device-to-device (device-to-device, D2D) communication, vehicle-to-everything (vehicle-to-everything, V2X) communication, machine-to-machine (machine-to-machine, M2M) communication, machine type communication (machine type communication, MTC), an internet of things (internet of things, IoT) communication system or another communication system, and the like. In addition, the technical solutions may be further extended to a similar wireless communication system, for example, a wireless fidelity (wireless-fidelity, Wi-Fi) system or a worldwide interoperability for microwave access (worldwide interoperability for microwave access, WIMAX) system. Optionally, the wireless communication system may comply with a wireless communication standard in the 3rd Generation Partnership Project (third generation partnership project, 3GPP), or may comply with another wireless communication standard, for example, a wireless communication standard in the 802 series (for example, 802.11, 802.15, or 802.20) of the Institute of Electrical and Electronics Engineers (institute of electrical and electronics engineers, IEEE). This is not limited.

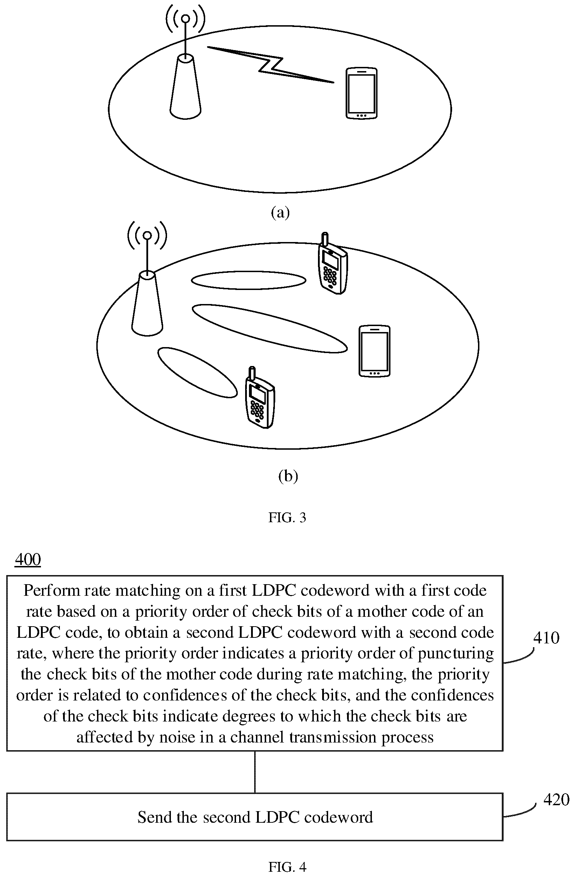

(a) and (b) in FIG. 3 are diagrams of system architectures applicable to an embodiment of this application. The wireless communication system includes at least one network device and one or more terminal devices. The at least one network device communicates with the one or more terminal devices by using a wireless communication technology. For example, (a) in FIG. 3 shows that a network device communicates with a single terminal device. (b) in FIG. 3 shows that a network device communicates with a plurality of terminal devices. Optionally, communication between the network device and the terminal device may further include downlink transmission in which the network device sends a signal to the terminal device, and uplink transmission in which the terminal device sends a signal to the network device. This is not limited in this specification. A transmit end (or an encoder) in the following embodiments may be the network device or the terminal device shown in FIG. 3. This is not limited.

The terminal device in embodiments of this application may also be referred to as user equipment (user equipment, UE), an access terminal, a subscriber unit, a subscriber station, a mobile station, a mobile console, a mobile terminal (mobile terminal, MT), a remote station, a remote terminal, a mobile device, a user terminal, a terminal, a wireless communication device, a user agent, or a user apparatus. The terminal device in embodiments of this application may be a device that provides voice and/or data connectivity for a user, and may be configured to connect a person, an object, and a machine, for example, a handheld device or a vehicle-mounted device with a wireless connection function. The terminal device in embodiments of this application may be a mobile phone (mobile phone), a tablet computer (pad), a notebook computer, a palmtop computer, a mobile internet device (mobile internet device, MID), a wearable device, a virtual reality (virtual reality, VR) device, an augmented reality (augmented reality, AR) device, a wireless terminal in industrial control (industrial control), a wireless terminal in self driving (self driving), a wireless terminal in remote medical surgery (remote medical surgery), a wireless terminal in a smart grid (smart grid), a wireless terminal in transportation safety (transportation safety), a wireless terminal in a smart city (smart city), a wireless terminal in a smart home (smart home), or the like. Optionally, the UE may serve as a base station. For example, the UE may serve as a scheduling entity that provides a sidelink signal between UEs in V2X, D2D, or the like.

In embodiments of this application, an apparatus configured to implement a function of the terminal may be a terminal, or may be an apparatus that can support the terminal in implementing the function, for example, a chip system or a chip. The apparatus may be installed in the terminal. In embodiments of this application, the chip system may include a chip, or may include a chip and another discrete component.

For example, in embodiments of this application, the network device may be a device with a wireless transceiver function. The network device may be a device that provides a wireless communication function service and is usually located on a network side, including but not limited to: a next-generation NodeB (gNodeB, gNB) in a 5th generation (5th generation, 5G) communication system, a base station in a 6th generation (6th generation, 6G) mobile communication system, a base station in a future mobile communication system, an access node in a wireless fidelity (wireless fidelity, Wi-Fi) system, an evolved NodeB (evolved NodeB, eNB) in a long term evolution (long term evolution, LTE) system, a radio network controller (radio network controller, RNC), a NodeB (NodeB, NB), a base station controller (base station controller, BSC), a home base station (for example, a home evolved NodeB, or a home NodeB, HNB), a baseband unit (baseband unit, BBU), a transmission reception point (transmission reception point, TRP), a transmission point (transmitting point, TP), a base transceiver station (base transceiver station, BTS), or the like. In a network structure, the network device may include a central unit (central unit, CU) node, a distributed unit (distributed unit, DU) node, a RAN device including a CU node and a DU node, or a RAN device including a CU-control plane node, a CU-user plane node, and a DU node. Alternatively, the network device may be a radio controller, a relay station, a vehicle-mounted device, a wearable device, and the like in a cloud radio access network (cloud radio access network, CRAN) scenario. In addition, the base station may be a macro base station, a micro base station, a relay node, a donor node, or a combination thereof. The base station may alternatively be a communication module, a modem, or a chip disposed in the foregoing device or apparatus. The base station may alternatively be a mobile switching center, a device that bears a base station function in D2D, V2X, and M2M communication, a network side device in a 6G network, a device that bears a base station function in a future communication system, or the like. The base station may support networks of a same access technology or different access technologies. This is not limited.

In embodiments of this application, an apparatus configured to implement a function of the network device may be a network device, or may be an apparatus that can support the network device in implementing the function, for example, a chip system or a chip. The apparatus may be installed in the network device. In embodiments of this application, the chip system may include a chip, or may include a chip and another discrete component.

To improve a system throughput, this application provides a rate matching method, which may be applied to a rate matching process of an LDPC code. Specifically, rate matching in this application mainly relates to puncturing. When a check matrix the LDPC code in the 802.11ac standard is reused, a code rate at a smaller granularity can be obtained by puncturing check bits in an LDPC codeword. A receive end may obtain a performance gain and improve decoding performance by combining codeword bits of different code rates.

FIG. 4 is a schematic flowchart of a rate matching method according to this application.

410: A transmit end performs rate matching on a first LDPC codeword with a first code rate based on a priority order of check bits of a mother code, to obtain a second LDPC codeword with a second code rate.

The priority order indicates a priority order of puncturing the check bits of the mother code corresponding to the first LDPC codeword during rate matching. The priority order is related to confidences of the check bits of the mother code, and the confidences of the check bits indicate degrees to which the check bits are affected by noise in a channel transmission process. For example, a confidence of a check bit that is susceptible to noise is lower than a confidence of a check bit that is not susceptible to noise. In other words, a check bit that is more easily affected by noise is more sensitive to noise, and a confidence of the check bit is lower. On the contrary, a check bit that is less easily affected by noise is less sensitive to noise, and a confidence of the check bit is higher. Alternatively, the confidence may also be referred to as reliability or the like.

A higher confidence of a check bit indicates a higher priority of puncturing the check bit during rate matching, or a higher priority of the check bit. On the contrary, a lower confidence of the check bit indicates a lower priority of puncturing the check bit during rate matching.

In an example, the priority order of the check bits is a descending order of priorities. In this case, a check bit with a higher confidence ranks higher in the priority order, and a check bit with a lower confidence ranks lower in the priority order.

In another example, the priority order of the check bits may alternatively be an ascending order of priorities. This is not limited in this specification. In this case, a check bit with a lower confidence ranks higher in the priority order, and a check bit with a higher confidence ranks lower in the priority order.

In the following embodiments, description is made by using an example in which the priority order is a descending order of confidences.

It should be understood that the mother code in this specification is an LDPC codeword obtained by performing LDPC encoding on system bits (system bits) based on a check matrix. In other words, the mother code is an LDPC codeword on which no rate matching is performed. In this specification, a code length of the mother code is denoted as N, and a code rate of the mother code is denoted as R.

In an embodiment, the first LDPC codeword may be the mother code. In this case, the first code rate of the first LDCP codeword is the code rate of the mother code. That is, LDPC encoding is performed on k system bits to obtain the first LDPC codeword, and a code rate of the first LDPC codeword is the first code rate.

The transmit end punctures the check bits of the first LDPC codeword based on the priority order of the check bits of the mother code, to obtain the second LDPC codeword with a higher code rate.

In another embodiment, the first LDPC codeword may be an LDPC codeword obtained through rate matching. For example, the first LDPC codeword may be an LDPC codeword obtained by puncturing the mother code. In this case, the first code rate of the first LDPC codeword is higher than the code rate of the mother code.

The transmit end punctures the first LDPC codeword based on the priority order of the check bits of the mother code, to obtain the second LDPC codeword. A code rate of the second LDPC codeword is higher than the first code rate.

Alternatively, the transmit end gradually fills a puncturing position of the first LDPC codeword based on the priority order of the check bits of the mother code, to gradually obtain an LDPC codeword with a lower code rate. In this case, rate matching is performed on the first LDPC codeword, to obtain the second LDPC codeword with a lower code rate. In other words, the second code rate is lower than the first code rate.

It can be learned that the priority order of the check bits of the mother code provided in this application is used for rate matching of the LDPC codeword. A puncturing position may be added to a puncturing pattern of an LDPC codeword with a low code rate, to obtain a high code rate. In addition, the transmit end may alternatively fill a puncturing position on a puncturing pattern of an LDPC codeword with a high code rate, to obtain a low code rate. In other words, a high code rate is compatible with a low code rate.

In the technical solutions provided in this application, priority orders of the check bits of the LDPC code with different code lengths are different. For example, when code lengths of the LDPC code are respectively 1944, 1296, or 648, the confidences of the check bits of the LDPC codeword may be different. Therefore, priorities of puncturing the check bits of the LDPC codeword with different lengths during rate matching are also different, and are separately provided below.

420: The transmit end sends the second LDPC codeword.

The transmit end performs rate matching on the LDPC codeword based on the priority order of puncturing the check bits of the mother code of the LDPC code during rate matching, so that puncturing performance can be improved.

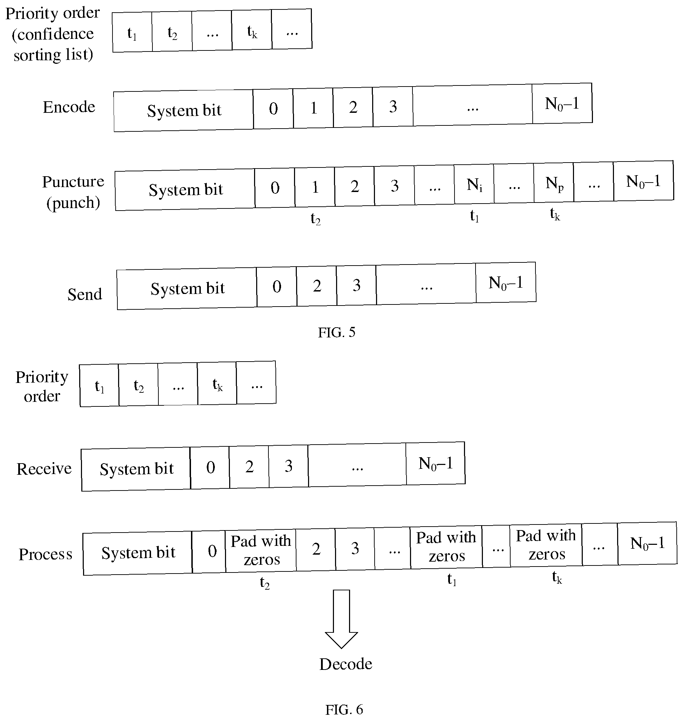

FIG. 5 is a diagram of a rate matching process of an LDPC code according to this application. As shown in FIG. 5, it is assumed that a descending order of priorities of check bits of an LDPC code whose code length is N and whose code rate is R is $t_1, t_2, ..., t_k, ....$

The transmit end performs LDPC encoding on an information bit sequence (or system bits) to obtain an LDPC codeword, where the LDPC codeword includes k system bits and $N_0$ check bits.

According to the rate matching solution provided in this application, the transmit-end device performs, based on the priority order of the check bits of the mother code of the LDPC code, rate matching on the LDPC codeword obtained through encoding. Specifically, it is assumed that a quantity of check bits that need to be punctured and that are determined by the transmit end based on a target code rate is $N_p$. For example, the priority order of the check bits of the mother code is a descending order of priorities. Assuming that the priority order is represented as $t_1, t_2, ..., t_k$, the transmit end selects, based on the priority order of the check bits, the first $N_p$ check bits from $t_1, t_2, ..., t_k, ...,$ and records bit positions corresponding to the $N_p$ check bits. It should be understood that $t_1, t_2, ..., t_k, ...$ are indexes of the check bits. For example, $t_1$ is an index of a check bit with a highest confidence, and confidences are in descending order from front to back. In a rate matching process, the transmit end punctures check bits in the $N_p$ bit positions of the LDPC codeword output through encoding. Then, the transmit end sends a punctured LDPC codeword.

The following describes a decoding process at a receive end with reference to FIG. 6.

FIG. 6 is a diagram of a decoding process at a receive end. The receive end stores information about the priority order of the check bits of the mother code, where the priority order indicates a priority order of puncturing the check bits of the mother code during rate matching. The priority order is related to confidences of the check bits of the mother code, and the confidences of the check bits indicate degrees to which the check bits are affected by noise in a channel transmission process. It should be understood that the priority order of the check bits of the mother code stored by the receive end is the same as the priority order of the check bits of the mother code stored by the transmit end, namely, $t_1, t_2, ..., t_k, ....$ The receive

end receives a channel receiving sequence, where the channel receiving sequence corresponds to a system bit part and a check bit part. In the technical solutions of this application, the check bit part is punctured. The receive end pads corresponding positions of the channel receiving sequence with zeros based on the priority order of the check bits of the mother code, and then decodes an LLR sequence corresponding to the channel receiving sequence that is padded with zeros. Specifically, the receive end may determine, based on the priority order and the quantity $N_p$ of to-be-punctured bits, the bit positions corresponding to the first $N_p$ check bits in descending order of priorities, and the receive end pads the positions corresponding to the $N_p$ check bits with zeros. Therefore, positions of the check bits punctured by the transmit end during rate matching are positions that need to be padded with zeros before the receive end performs decoding.

The following describes a principle that decoding performance can be improved by puncturing the LDPC code based on the priority order of the check bits proposed in this application.

In this application, it is proposed that a position of a check bit that is insensitive to noise impact (that is, a check bit that is not easily affected by noise) is determined by collecting statistics on a confidence feature. IR-HARQ requires that the code rate of the LDPC codeword at the receive end be compatible, that is, bits transmitted at a high code rate are included in bits transmitted at a low code rate. The IR-HARQ preferentially punctures (or referred to as punching) these check bits that are not easily affected by noise and that have high confidences. This can ensure restorability of a system variable node, especially when a quantity of punctured bits is large. In addition, because a bit with a higher confidence is more likely to be correctly restored, a check bit with a higher confidence is preferentially punctured, so that more valid information can be provided for another system variable node in an iterative decoding process, thereby helping improve puncturing performance.

Optionally, in an example, sensitivity of a check bit of an LDPC code is first defined based on the following process.

First, a fixed source is an all-zero source. When there is no noise, iterative calculation is performed for a specific quantity of iterations on an LDPC codeword on which no rate matching is performed (or a to-be-punctured LDPC codeword). For example, the quantity of iterations is compared with a specified threshold n. After iterative decoding is converged, an absolute value |LLR| of a log-likelihood ratio (likelihood rate, LLR) of iterative decoding is used as a confidence feature, to determine a confidence order of the check bits, or determine a sensitivity order of the check bits. A smaller value of |LLR| indicates that a bit position corresponding to |LLR| is more sensitive and a confidence is lower.

It should be noted that, because the LDPC code is a linear code, and a sensitivity order of the check bits determined by using different sources are similar, distribution characteristics of cycles and degrees to which different check bits belong are the same, and puncturing performance is basically the same. Therefore, in the technical solutions of this application, an example in which a fixed source is an all-zero source is used.

Check bits of the to-be-punctured LDPC codeword are sorted in descending order of confidences, and a sorting relationship of the check bits is stored in Table T. Table T is an order table of sensitivity of check bits, that is, an order table of a priority order of check bits in this application. In the order table, check bits with high confidences are arranged in the front, and check bits with low confidences are arranged in the back.

For example, Table T may be represented by using the following formula (1):

$$\mathrm{T} = \left( t_1, t_2, \dots, t_{\frac{K}{R}-K} \right) \tag{1}$$

T is a confidence order table of columns included in a check part of a check matrix. A quantity of columns included in T may be represented as $\frac{K}{R} - K$, where K represents a quantity of columns corresponding to system bits in the check matrix, R represents a code rate, and $\frac{K}{R} - K$ may represent a quantity of columns corresponding to check bits in the check matrix, that is, a quantity of columns included in the check part. For example, if T is arranged in descending order of confidences, $t_1$ represents a column index of a column with a highest confidence in the check matrix, and $t_{\frac{K}{R}-K}$ is an index of a column with a lowest confidence in the check matrix.

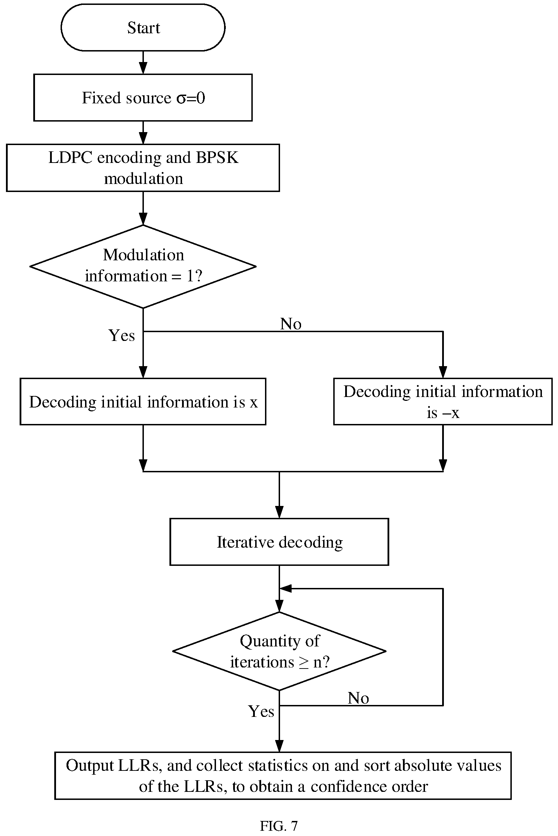

The following describes a process of establishing a confidence order of check bits with reference to FIG. 7.

FIG. 7 is a flowchart of obtaining a confidence order of check bits according to this application. As shown in FIG. 7, in a noise-free environment, an all-zero source is fixed, LDPC encoding with a corresponding code rate and code length is performed, and then modulation is performed, for example, binary phase shift keying (binary phase shift keying, BPSK) modulation is performed. Decoding initial information is set to a fixed value ± x, and then sent to an iterative decoder for decoding. After a specific quantity of iterations (for example, n times), LLRs of the check bits are output, and absolute values |LLR| of the LLRs are sorted, for example, are sorted in descending order.

Optionally, the iterative decoder may be specifically a log-SPA iterative decoder. SPA indicates a sum-product algorithm (sum-product algorithm), which is a type of LDPC decoding algorithm based on iterative decoding, and belongs to a soft-decision algorithm. When a log-SPA decoding algorithm is used, decoding initial information of an additive white Gaussian noise (additive white Gaussian noise, AWGN) channel is $y/\sigma^2$, where y is channel information, and $\sigma^2$ is a noise variance. When the noise variance is 0, the decoding initial information should be $\pm\infty$. If this is set directly in a computer program, data overflow occurs. Therefore, when check information is solved, a function shown in formula (2) is used:

$$\varphi(x) = \log\frac{e^x+1}{e^x-1} \qquad (2)$$

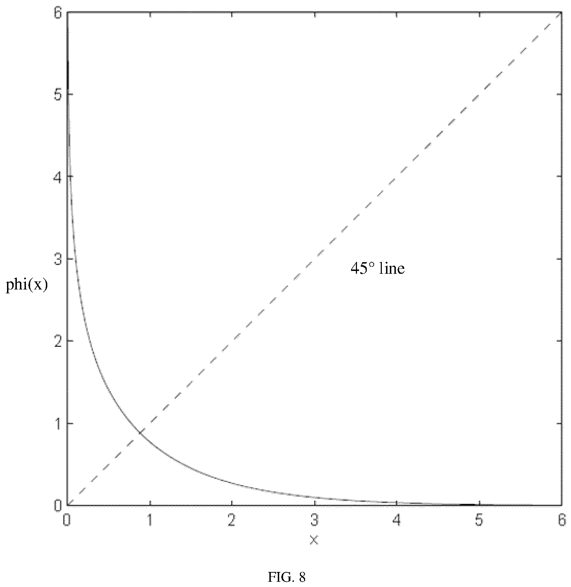

A function property of $\varphi(x)$ is shown in FIG. 8. FIG. 8 shows an image of a function $\varphi(x)$ used to determine a confidence order of check bits according to an embodiment of this application. A horizontal axis x represents a value of a log-likelihood ratio transferred in an LDPC iterative decoding process, that is, an LLR value, and a vertical axis phi(x) represents a function about x, that is, $\varphi(x)$.

Optionally, as an example, in actual decoding, the decoding initial value x may be set to 3, 4, 5, or the like.

The following provides a priority order of the check bits of the LDPC codeword when a code rate is 1/2 and code lengths are 1944, 1296, and 648 in this application.

(1) A code rate R = 1/2, and a code length L = 1944.

First, a check matrix of the LDPC code whose code rate is 1/2 and whose code length is 1944 is provided as follows:

$$
\begin{bmatrix}
57 & - & - & - & 50 & - & 11 & - & 50 & - & 79 & - & 1 & 0 & - & - & - & - & - & - & - & - & - & - \\
3 & - & 28 & - & 0 & - & - & - & 55 & 7 & - & - & - & 0 & 0 & - & - & - & - & - & - & - & - & - \\
30 & - & - & - & 24 & 37 & - & - & 56 & 14 & - & - & - & - & 0 & 0 & - & - & - & - & - & - & - & - \\
62 & 53 & - & - & 53 & - & - & 3 & 35 & - & - & - & - & - & - & 0 & 0 & - & - & - & - & - & - & - \\
40 & - & - & 20 & 66 & - & - & 22 & 28 & - & - & - & - & - & - & - & 0 & 0 & - & - & - & - & - & - \\
0 & - & - & - & 8 & - & 42 & - & 50 & - & - & 8 & - & - & - & - & - & 0 & 0 & - & - & - & - & - \\
69 & 79 & 79 & - & - & - & 56 & - & 52 & - & - & - & 0 & - & - & - & - & - & 0 & 0 & - & - & - & - \\
65 & - & - & - & 38 & 42 & - & - & 72 & - & 27 & - & - & - & - & - & - & - & - & 0 & 0 & - & - & - \\
64 & - & - & - & 14 & 56 & - & - & 30 & - & - & 32 & - & - & - & - & - & - & - & - & 0 & 0 & - & - \\
- & 45 & - & 70 & 0 & - & - & - & 77 & 9 & - & - & - & - & - & - & - & - & - & - & - & 0 & 0 & - \\
2 & 56 & - & 57 & 35 & - & - & - & - & - & 12 & - & - & - & - & - & - & - & - & - & - & - & 0 & 0 \\
24 & - & 61 & - & 60 & - & - & 27 & 51 & - & - & 16 & 1 & - & - & - & - & - & - & - & - & - & - & 0
\end{bmatrix}
$$

As shown above, a size of the check matrix is 12×24, and each element in the check matrix represents a z=1944/24=81-order square matrix. "-" represents an all-zero matrix of 81 ×81. Each element i in the check matrix represents a circulant permutation matrix of 81 ×81, and i represents a cyclic shift value. For example, i=0 indicates an identity matrix whose size is 81 ×81, and i=1 indicates a cyclic shift matrix shown in the following formula (3):

$$
\begin{bmatrix}
0 & 1 & 0 & \cdots & 0 \\
0 & 0 & 1 & \cdots & 0 \\
\vdots & \vdots & \vdots & \ddots & \vdots \\
0 & 0 & 0 & \cdots & 1 \\
1 & 0 & 0 & \cdots & 0
\end{bmatrix} \qquad (3)
$$

It should be understood that the check matrix includes a check part, and the check part includes columns used for the check bits. In addition, it may be noted that columns related to the order in Table 1 include a 13th column to a 24th column of the check matrix. This is because the 13th column to the 24th column of the check matrix whose code rate is 1/2 and whose code length is 1944 correspond to the check part of the check matrix. Codeword bits corresponding to the part of columns are all check bits generated through encoding. According to the method for sorting the confidences of the check bits provided in this application, the check part in the check matrix of the LDPC code whose code rate is 1/2 and whose code length is 1944 is the 13th column to the 24th column of the check matrix. Optionally, the priority order of the confidences of the check bits may be a priority order of the columns included in the check part. As an example, a descending order of

priorities of the 13th column to the 24th column included in the check part is, for example, the following order 1:
13, 14, 24, 15, 23, 16, 22, 17, 21, 18, 20, 19.

It can be learned from the foregoing descriptions of the check matrix that each column of a mother matrix of the check matrix corresponds to z check bits of a mother code. It can be learned that each column included in the check part of the check matrix of the LDPC code whose code rate is 1/2 and whose code length is 1944 provided above corresponds to the z check bits of the mother code, and z = 1944/24 = 81. Specifically, each column in the 13th column to the 24th column of the check matrix of the LDPC code whose code rate is 1/2 and whose code length is 1944 corresponds to 81 check bits.

In a rate matching process, a check bit corresponding to a column with a high priority is first considered to be punctured. The order 1 is used as an example. If a quantity of check bits that need to be punctured during rate matching is exactly 81, 81 check bits corresponding to the 13th column of the check matrix are punctured. If a quantity of check bits that need to be punctured is 81×2, 81 check bits respectively corresponding to the 13th column and the 14th column of the check matrix are punctured, and so on. In descending order of priorities of columns shown in the order 1, puncturing of a required quantity of check bits is completed.

Further, in this application, priorities of check bits in any column included in the check part of the check matrix are the same.

The order 1 is used as an example. The 13th column corresponds to 81 check bits, and priorities of the 81 check bits are the same. For another example, the 14th column corresponds to 81 check bits, and priorities of the 81 check bits corresponding to the 14th column are the same. A same principle applies to other columns in the order 1.

Without loss of generality, it is assumed that a quantity of to-be-punctured bits during rate matching is L. In a possible case, if L < z, the transmit end selects, for puncturing, L check bits in z check bits corresponding to a highest-priority column in the priority order of the check bits. The L check bits are any L check bits in the z check bits corresponding to the highest-priority column in the columns (specifically, the 13th column to the 24th column) included in the check part. In other words, the L check bits may be L check bits randomly selected from the z check bits corresponding to the highest-priority column. If the order 1 is used as an example, the L check bits are any L check bits of the 81 check bits corresponding to the 13th column in the check part.

In another possible case, L = mz, and the transmit end selects, for puncturing, check bits corresponding to the first m columns in the priority order of the check bits that are sorted in descending order of priorities. In this case, the quantity of to-be-punctured bits is equal to a quantity of check bits corresponding to m columns in the check part of the check matrix. In this case, the transmit end punctures, based on the first m columns in descending order of priorities, the check bits corresponding to the m columns.

The following uses the LDPC code whose code rate is 1/2 and whose code length is 1944 (that is, z = 81) as an example to describe selection of a puncturing position of a check bit. If the LDPC code whose code rate is 1/2 and whose code length is 1296 (that is, z = 54) or the LDPC code whose code rate is 1/2 and whose code length is 684 (that is, z = 27) is used, a same criterion is used for selecting a puncturing position of a check bit.

The order 1 is used as an example. For example, if a quantity of to-be-punctured bits that is determined based on a target code rate is 81, 81 check bits corresponding to the 13th column are preferentially punctured. For another example, if a quantity of to-be-punctured bits is 81×2, the transmit end punctures 81 check bits corresponding to the 13th column and 81 check bits corresponding to the 14th column.

In another possible case, L > z. In this case, the transmit end selects, for puncturing, L check bits in tz check bits corresponding to the first t columns sorted in descending order of priorities. The L check bits include z(t-1) check bits corresponding to the first t-1 columns in the t columns and p check bits in a tth column, the p check bits are any p check bits in z check bits corresponding to the tth column, both t and p are positive integers, and p ≤ z.

The order 1 is used as an example. For example, assuming that a quantity of to-be-punctured bits is 100, and 100 = 81 × 1 + 19, the transmit end punctures 81 check bits corresponding to the 13th column, and punctures 19 check bits in 81 check bits corresponding to the 14th column. Because priorities of z check bits corresponding to a same column are the same, the 19 check bits may be 19 check bits randomly selected from the 81 check bits corresponding to the 14th column.

For another example, if a quantity of to-be-punctured bits is 190, and 190 = 81 × 2 + 28, the transmit end punctures 81 check bits corresponding to the 13th column and 81 check bits corresponding to the 14th column, and punctures any 28 check bits in 81 check bits corresponding to the 24th column.

It should be noted that a column index in the order 1 is based on a column index of the check matrix and starts from 1. In other words, when column indexes of the check matrix of the mother code whose code length is 1944 and whose code rate is 1/2 are represented by using 1 to 24, the check part in the check matrix is the 13th column to the 24th column of the check matrix. Optionally, an index range of the 13th column to the 24th column included in the check part may be represented as 13 to 24.

In another possible representation manner, a column index of a check matrix of a mother code may start from 0, and the column index of the check matrix ranges from 0 to 23. An index of a column that corresponds to a check bit and that is in the check matrix should range from 12 to 23.

In the latter representation, a descending order of priorities of puncturing, during rate matching, the columns included in the check part of the check matrix of the LDPC code whose code rate is 1/2 and whose code length is 1944 is, for example, the following order 2:

12, 13, 23, 14, 22, 15, 21, 16, 20, 17, 19, 18.

It should be understood that the order 1 and the order 2 are equivalent, and both represent priorities of puncturing, during rate matching, the columns corresponding to the check bits in the check matrix of the LDPC code whose code rate is 1/2 and whose code length is 1944. A difference lies only in a different representation manner of the column index of the check matrix.

It may be understood that puncturing the check bits can further ensure restorability of the system bits, especially when a large quantity of bits need to be punctured. In addition, a check bit with a high confidence is preferentially punctured, so that more valid information can be provided for another system variable node in an iterative decoding process, to improve decoding performance.

Absolute values of LLRs of the check bits in the check matrix corresponding to the LDPC code whose code rate is 1/2 and whose code length is 1944 and a confidence order of the check bits may be shown in Table 1. For example, the priority order of the check bits may be a descending order of confidences.

Table 1

| Confidence order | 13(3) | 14(2) | 24(2) | 15(2) | 23(2) | 16(2) |
|---|---|---|---|---|---|---|
| \|LLR\| | 32.5925 | 32.5114 | 32.3636 | 30.6696 | 30.6309 | 29.2333 |
| Confidence order | 22(2) | 17(2) | 21(2) | 18(2) | 20(2) | 19(2) |
| \|LLR\| | 29.1414 | 28.1107 | 27.9524 | 27.3161 | 27.1948 | 26.9747 |

In a 1st row "confidence order" in Table 1, each element a(b) represents an $a^{th}$ column of the check matrix, and a column weight of the $a^{th}$ column is b. \|LLR\| corresponding to the $a^{th}$ column represents an absolute value of an LLR of a check bit of the $a^{th}$ column, and may reflect a confidence of the check bit corresponding to the column. A larger value of \|LLR\| indicates a higher confidence, and on the contrary, a smaller value of \|LLR\| indicates a lower confidence. For example, 13(3) in Table 1 represents the $13^{th}$ column of the check matrix, and a column weight of the $13^{th}$ column is 3.

In addition, in the confidence order in Table 1, an index of a column included in the check part of the check matrix ranges from 1 to 24. Optionally, the column included in the check part may alternatively be represented by indexes 0 to 23. Alternatively, information to be expressed in Table 1 may be recorded in another variation form. All the foregoing variation forms should fall within the scope of embodiments of this application.

Table 2 shows comparison between a confidence-based puncturing scheme provided in this application, a scheme of puncturing unreliable check bits, and a puncturing scheme in the 802.11 ac standard.

Table 2

| | Puncturing two columns | Puncturing four columns | Puncturing six columns | Puncturing eight columns | Puncturing nine columns |
|---|---|---|---|---|---|
| Confidence-based puncturing scheme in this application | 13, 14 | 13, 14, 24, 15 | 13, 14, 24, 15, 23, 16 | 13, 14, 24, 15, 23, 16, 22, 17 | 13, 14, 24, 15, 23, 16, 22, 17, 21 |
| Puncturing unreliable check bits | 19, 20 | 19, 20, 18, 21 | 19, 20, 18, 21, 17 | 19, 20, 18, 21, 17, 22, 16, 23 | 19, 20, 18, 21, 17, 22, 16, 23, 15 |
| Puncturing scheme in the 802.11ac standard | 24, 23 | 24, 23, 22, 21 | 24, 23, 22, 21, 20, 19 | 24, 23, 22, 21, 20, 19, 18, 17 | 24, 23, 22, 21, 20, 19, 18, 17, 16 |

Table 2 shows indexes (a column index starts from 1) of corresponding columns of check bits that are preferentially punctured in the check matrix according to the confidence-based puncturing scheme provided in this application when a quantity of check bits that need to be punctured is $81 \times 2$, $81 \times 4$, $81 \times 6$, or the like. In comparison, the puncturing scheme in the 802.11ac standard is that puncturing priorities of the $24^{th}$ column to the $16^{th}$ column of the check matrix are in descending order. In addition, Table 2 further shows an example of puncturing bits in ascending order of confidences according to the confidence-based puncturing scheme provided in this application, for example, a middle row (puncturing unreliable check bits) in Table 2. In the scheme of puncturing unreliable check bits, the transmit end punctures check bits in ascending order of confidences. In other words, a check bit with a low confidence is preferentially punctured.

In addition, it can be further found from Table 2 that, in the technical solutions of this application, for a specific code length, a puncturing position set of check bits of an LDPC codeword with a high code rate includes a puncturing position set of check bits of an LDPC codeword with a low code rate. In other words, the puncturing position set of the check bits of the LDPC codeword with the low code rate is a proper subset of the puncturing position set of the check bits of the LDPC codeword with the high code rate.

For example, when a quantity of punctured bits is $81 \times 2$ (that is, two columns), the puncturing position set of the LDPC codeword is represented by using a column that corresponds to a check bit and that is in the check matrix, and a set of indexes of punctured columns is {13, 14}.

When a quantity of punctured bits is $81 \times 4$ (that is, four columns), the puncturing position set of the LDPC codeword is represented by using a column that corresponds to a check bit and that is in the check matrix, and a set of indexes of punctured columns is {13, 14, 24, 15}.

When a quantity of punctured bits is $81 \times 6$ (that is, six columns), the puncturing position set of the LDPC codeword is represented by using a column that corresponds to a check bit and that is in the check matrix, and a set of indexes of punctured columns is {13, 14, 24, 15, 23, 16}.

It may be learned from the puncturing principle that a larger quantity of punctured bits indicates a higher code rate of the LDPC codeword. Therefore, a puncturing position set of an LDPC codeword with a low code rate is a proper subset of a puncturing position set of an LDPC codeword with a high code rate. In other words, in the puncturing scheme in this application, a high code rate is compatible with a low code rate. That is, a new puncturing position is added to the puncturing position set of the LDPC codeword with the low code rate, to obtain a puncturing position set of an LDPC code with a higher code rate.

(2) A code rate R = 1/2, and a code length L = 1296.

In the following, a check matrix of the LDPC code whose code rate is 1/2 and whose code length is 1296 is first provided as follows:

$$
\begin{bmatrix}
40 & - & - & - & 22 & - & 49 & 23 & 43 & - & - & - & 1 & 0 & - & - & - & - & - & - & - & - & - & - \\
50 & 1 & - & - & 48 & 35 & - & - & 13 & - & 30 & - & - & 0 & 0 & - & - & - & - & - & - & - & - & - \\
39 & 50 & - & - & 4 & - & 2 & - & - & - & - & 49 & - & - & 0 & 0 & - & - & - & - & - & - & - & - \\
33 & - & - & 38 & 37 & - & - & 4 & 1 & - & - & - & - & - & - & 0 & 0 & - & - & - & - & - & - & - \\
45 & - & - & - & 0 & 22 & - & - & 20 & 42 & - & - & - & - & - & - & 0 & 0 & - & - & - & - & - & - \\
51 & - & - & 48 & 35 & - & - & - & 44 & - & 18 & - & - & - & - & - & - & 0 & 0 & - & - & - & - & - \\
47 & 11 & - & - & - & 17 & - & - & 51 & - & - & - & 0 & - & - & - & - & - & 0 & 0 & - & - & - & - \\
5 & - & 25 & - & 6 & - & 45 & - & 13 & 40 & - & - & - & - & - & - & - & - & - & 0 & 0 & - & - & - \\
33 & - & - & 34 & 24 & - & - & - & 23 & - & - & 46 & - & - & - & - & - & - & - & - & 0 & 0 & - & - \\
1 & - & 27 & - & 1 & - & - & - & 38 & - & 44 & - & - & - & - & - & - & - & - & - & - & 0 & 0 & - \\
- & 18 & - & - & 23 & - & - & 8 & 0 & 35 & - & - & - & - & - & - & - & - & - & - & - & - & 0 & 0 \\
49 & - & 17 & - & 30 & - & - & - & 34 & - & - & 19 & 1 & - & - & - & - & - & - & - & - & - & - & 0
\end{bmatrix}
$$

As shown above, a size of the check matrix is $12 \times 24$, and each element in the check matrix represents a z=1296/24=54-order square matrix. "-" represents an all-zero matrix of $54 \times 54$. Each element i in the check matrix represents a circulant permutation matrix of $54 \times 54$, and i represents a cyclic shift value. For example, i=0 indicates an identity matrix whose size is $54 \times 54$, and i=1 indicates a cyclic shift matrix whose cyclic shift value is 1.

According to the method for sorting the confidences (or sensitivity to noise) of the check bits provided in this application, a descending order of priorities of puncturing, during rate matching, the columns (namely, the columns included in the check part of the check matrix) corresponding to the check bits in the check matrix of the LDPC code whose code rate is 1/2 and whose code length is 1296 is, for example, the following order 3:

13, 17, 22, 18, 24, 16, 23, 19, 14, 21, 15, 20

Similarly, the order 3 is represented based on a column index range of the check matrix being 1 to 24. If the column index of the check matrix starts from 0, a descending order of priorities of puncturing, during rate matching, the columns corresponding to the check bits in the check matrix of the LDPC codeword whose code rate is 1/2 and whose code length is 1296 is, for example, the following order 4.

12, 16, 21, 17, 23, 16, 22, 18, 13, 20, 14, 19.

Absolute values of LLRs of the check bits in the check matrix corresponding to the LDPC codeword whose code rate is 1/2 and whose code length is 1944 and a reliability order of the check bits may be shown in Table 3.

Table 3

| Confidence order | 13(3) | 17(2) | 22(2) | 18(2) | 24(2) | 16(2) |
|---|---|---|---|---|---|---|
| |LLR| | 2.0309 | 1.8295 | 1.8287 | 1.8260 | 1.7985 | 1.7834 |
| Confidence order | 23(2) | 19(2) | 14(2) | 21(2) | 15(2) | 20(2) |
| |LLR| | 1.7805 | 1.7793 | 1.7627 | 1.7496 | 1.6992 | 1.6921 |

In a 1st row "confidence order" in Table 3, each element a(b) represents an $a^{th}$ column of the check matrix, and a column weight of the $a^{th}$ column is b. |LLR| corresponding to the $a^{th}$ column represents |LLR| of a check bit of the $a^{th}$ column.

Similar to the foregoing LDPC codeword whose code length is 1944, because only the confidences of the check bits are sorted in this application, Table 3 shows the check part of the check matrix of the LDPC codeword whose code rate is 1/2 and whose code length is 1296. In other words, the confidence order of the check bits in the $13^{th}$ column to the $24^{th}$ column of the check matrix is the priority order of the check bits in this application.

In the confidence order in Table 3, a column index of the check matrix ranges from 1 to 24, or may be represented by 0 to 23. This is not limited.

In addition, each column of the check matrix of the LDPC codeword whose code rate is 1/2 and whose code length is 1296 corresponds to 54 check bits of the mother code. Priorities of check bits corresponding to any column included in the check part of the check matrix are the same. For example, the $13^{th}$ column with a highest priority corresponds to 54 check bits of the mother code, and priorities of the 54 check bits are the same. If the transmit end needs to puncture t check bits in the $13^{th}$ column, and t < 54, the t check bits may be randomly selected from the 54 check bits in the $13^{th}$ column. Other columns in Table 3 are similar, and details are not described again.

(3) A code rate R = 1/2, and a code length L = 648.

In the following, a check matrix of the LDPC codeword whose code rate is 1/2 and whose code length is 648 is first provided as follows:

$$
\begin{bmatrix}
0 & - & - & - & 0 & 0 & - & - & 0 & - & - & 0 & 1 & 0 & - & - & - & - & - & - & - & - & - & - \\
22 & 0 & - & - & 17 & - & 0 & 0 & 12 & - & - & - & - & 0 & 0 & - & - & - & - & - & - & - & - & - \\
6 & - & 0 & - & 10 & - & - & - & 24 & - & 0 & - & - & - & 0 & 0 & - & - & - & - & - & - & - & - \\
2 & - & - & 0 & 20 & - & - & - & 25 & 0 & - & - & - & - & - & 0 & 0 & - & - & - & - & - & - & - \\
23 & - & - & - & 3 & - & - & - & 0 & - & 9 & 11 & - & - & - & - & 0 & 0 & - & - & - & - & - & - \\
24 & - & 23 & 1 & 17 & - & 3 & - & 10 & - & - & - & - & - & - & - & - & 0 & 0 & - & - & - & - & - \\
25 & - & - & - & 8 & - & - & - & 7 & 18 & - & - & 0 & - & - & - & - & - & 0 & 0 & - & - & - & - \\
13 & 24 & - & - & 0 & - & 8 & - & 6 & - & - & - & - & - & - & - & - & - & - & 0 & 0 & - & - & - \\
7 & 20 & - & 16 & 22 & 10 & - & - & 23 & - & - & - & - & - & - & - & - & - & - & - & 0 & 0 & - & - \\
11 & - & - & - & 19 & - & - & - & 13 & - & 3 & 17 & - & - & - & - & - & - & - & - & - & 0 & 0 & - \\
25 & - & 8 & - & 23 & 18 & - & 14 & 9 & - & - & - & - & - & - & - & - & - & - & - & - & - & 0 & 0 \\
3 & - & - & - & 16 & - & - & 2 & 25 & 5 & - & - & 1 & - & - & - & - & - & - & - & - & - & - & 0
\end{bmatrix}
$$

As shown above, a size of the check matrix is 12×24, and each element in the check matrix represents a z=648/24=27-order square matrix. "-" represents an all-zero matrix of 27×27. Each element i in the check matrix represents a circulant permutation matrix of 27×27, and i represents a cyclic shift value. For example, i=0 indicates an identity matrix whose size is 27×27, and i=1 indicates a cyclic shift matrix whose cyclic shift value is 1.

According to the method for sorting the confidences of the check bits provided in this application, priorities of puncturing, during rate matching, the columns corresponding to the check bits in the check matrix of the LDPC codeword whose code rate is 1/2 and whose code length is 648 are sorted in descending order, for example, the following order 5: 13, 17, 16, 20, 24, 14, 19, 18, 23, 22, 15, 21.

Similarly, the order 5 is represented based on a column index range of the check matrix being 1 to 24. If the column index of the check matrix starts from 0, priorities of puncturing, during rate matching, the columns corresponding to the check bits in the check matrix of the LDPC codeword whose code rate is 1/2 and whose code length is 1296 are sorted in descending order, for example, the following order 6.

12, 16, 15, 19, 23, 13, 18, 17, 22, 21, 14, 20.

Absolute values $|LLR|$ of LLRs of the check bits in the check matrix corresponding to the LDPC codeword whose code rate is 1/2 and whose code length is 648 and a confidence order of the check bits may be shown in Table 4.

Table 4

| Confidence order | 13(3) | 17(2) | 16(2) | 20(2) | 24(2) | 14(2) |
|---|---|---|---|---|---|---|
| ILLRI | 2.6900 | 2.2851 | 2.2568 | 2.2364 | 2.1893 | 2.1816 |
| Confidence order | 19(2) | 18(2) | 23(2) | 22(2) | 15(2) | 21(2) |
| ILLRI | 2.1634 | 2.1630 | 2.1471 | 2.1389 | 2.1302 | 2.0989 |

In a 1st row "confidence order" in Table 4, each element a(b) represents an ath column of the check matrix, and a column weight of the ath column is b. $|LLR|$ corresponding to the ath column represents $|LLR|$ of a check bit of the ath column.

It may be understood that, because only the confidences of the check bits are sorted in this application, Table 4 shows the check part of the check matrix of the LDPC codeword whose code rate is 1/2 and whose code length is 1296. In other words, the confidence order of the check bits in the 13th column to the 24th column of the check matrix is the priority order of the check bits in this application.

Each column of the check matrix of the LDPC codeword whose code rate is 1/2 and whose code length is 648 corresponds to 27 check bits of the mother code. Priorities of check bits that belong to a same column in the check part of the check matrix are the same. For example, the 13th column with a highest priority corresponds to 27 check bits of the mother code, and priorities of the 27 check bits are the same. If the transmit end needs to puncture t check bits in the 13th column, and t < 27, the t check bits may be randomly selected from the 27 check bits in the 13th column. Other columns in Table 4 are similar, and details are not described again.

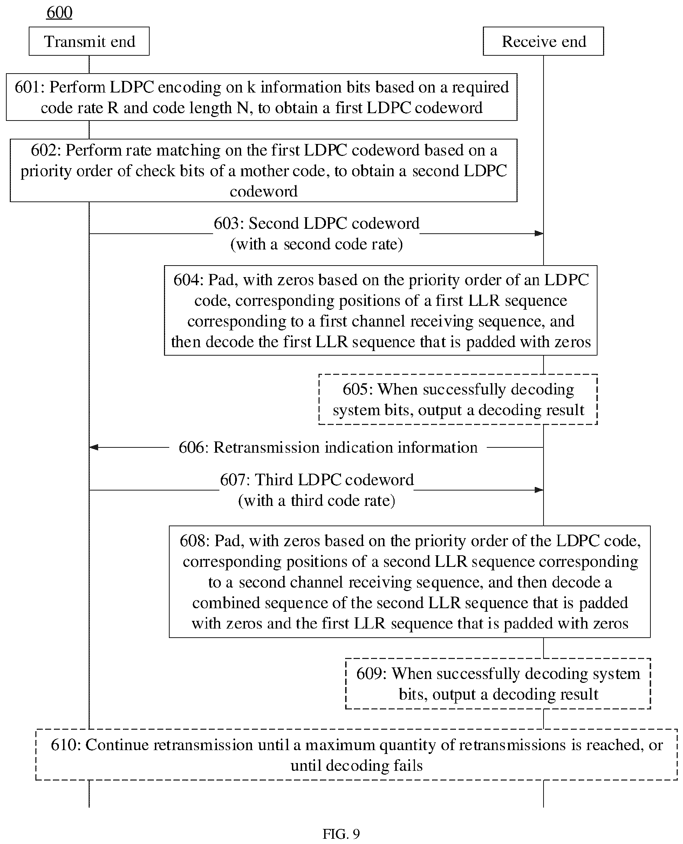

The foregoing describes in detail the rate matching method provided in this application. The following describes application of the technical solutions of this application in an IR-HARQ scenario with reference to FIG. 9. In the IR-HARQ scenario, as a quantity of retransmissions increases, more incremental redundant bits may be obtained by puncturing more check bits, so that a code rate continuously decreases. This can increase a probability of successful decoding at a receive end, and improve decoding performance.

FIG. 9 shows an application example of a rate matching method according to this application.

Optionally, an operation or processing performed by a receive end in the flowchart shown in FIG. 9 may also be performed by a chip, a circuit system, or the like disposed in a receive-end device. The circuit system may be, for example, an integrated circuit or a logic circuit. The chip may be a system-on-a-chip (system on a chip, SoC) chip, a baseband modem (modem) chip, or the like. This is not limited in this specification. The following uses the receive-end device as an example for description.

The receive end may be a terminal device or a network device. It should be understood that the receive end in embodiments of this application is also a decoding device. For example, in uplink transmission, a transmit end is a terminal device, and the receive end is a network device. In downlink transmission, the transmit end is a network device, and the receive end is a terminal device.

601: The transmit end performs LDPC encoding on k information bits (also referred to as system bits, system bits) based on a required code rate R and code length N, to obtain a first LDPC codeword. A code rate of the first LDPC codeword is R, a code length is N, where k and N are both integers.

It may be understood that the code rate R of the first LDPC codeword may be used as a basic code rate. For example, R may be 1/2. Based on this code rate, a higher code rate, for example, 2/3, 3/4, or 5/6 can be obtained by puncturing an LDPC code.

LDPC encoding is performed on an information bit sequence based on the foregoing provided check matrices whose code rates are 1/2 and whose code lengths are 1944, 1296, and 648, to obtain the first LDPC codeword whose code rate is 1/2 and whose code length is N. A value of N may be 1944, 1296, or 648, depending on a check matrix used during encoding.

For example, if the transmit end uses a check matrix corresponding to an LDPC code whose code rate is 1/2 and whose code length is 1944, the length of the first LDPC codeword obtained through encoding is 1944.

For another example, if the transmit end uses a check matrix corresponding to an LDPC code whose code rate is 1/2 and whose code length is 1296, the length of the first LDPC codeword obtained through encoding is 1296.

For another example, if the transmit end uses a check matrix corresponding to an LDPC code whose code rate is 1/2 and whose code length is 648, the length of the first LDPC codeword obtained through encoding is 648.

The following uses the code length N = 1944 as an example for description.

602: The transmit end performs rate matching on the first LDPC codeword based on a priority order of check bits of a mother code, to obtain a second LDPC codeword.

Based on a required code rate (or a target code rate) and a priority order (for example, the confidence order of the check bits in the foregoing embodiment) of check bits of a mother code whose code rate is 1/2 and whose code length N = 1944, the transmit end punctures check bits of the first LDPC codeword to obtain the second LDPC codeword with a second code rate.

In other words, the second LDPC codeword is a codeword obtained by puncturing the first LDPC codeword. Therefore, a code rate (that is, the second code rate) of the second LDPC codeword is greater than a first code rate.

In this embodiment, the LDPC codeword whose code rate is 1/2 is used as the basic codeword, and the basic codeword is punctured, to obtain a codeword with a higher code rate (that is, the second code rate).

603: The transmit end sends the second LDPC codeword.

The receive end receives a first channel receiving sequence from the transmit end.

604: The receive end pads, with zeros based on the priority order of the check bits of the LDPC code whose code rate is 1/2 and whose code length is N, corresponding positions of a first LLR sequence corresponding to the first channel receiving sequence, and then decodes the first LLR sequence that is padded with zeros.

As described in FIG. 6 above, before performing decoding, the receive end first pads, with zeros, bit positions corresponding to check bits punctured by the transmit end, and then performs decoding.

Because both the receive end and the transmit end store information about priority orders of check bits of LDPC codewords whose code rates are 1/2 and whose code lengths are different, the receive end may learn of positions of punctured check bits based on a current code rate and a current code length. Therefore, the receive end pads, with zeros, the positions of these punctured check bits before performing decoding.

The receive end decodes the first LLR sequence that is padded with zeros. In a possible case, the receive end successfully decodes all system bits of the second LDPC codeword. In this case, the receive end performs step 605.

605: When the receive end successfully decodes all the system bits, the receive end outputs a decoding result.

After step 605, communication of a next data packet is performed.

In another possible case, if the receive end fails to decode all the system bits, the receive end sends retransmission indication information to the transmit end, to request the transmit end to perform retransmission, as described in the following steps 606 to 608.

606: The receive end sends the retransmission indication information to the transmit end.

The retransmission indication information indicates the transmit end to retransmit the LDPC codeword. Optionally, the retransmission indication information may further indicate a part that is not correctly received. For example, the part that is not correctly received may be a codeword (codeword), a media access control protocol data unit (media access control protocol data unit, MPDU), or the like, depending on a specific configuration.

The transmit end receives the retransmission indication information from the receive end.

When the receive end does not correctly decode the system bits of the LDPC codeword, a mechanism in which the transmit end performs retransmission may have a plurality of specific implementations. A manner in which the receive end sends the retransmission indication information to the transmit end to request the transmit end to perform retransmission in FIG. 9 is merely used as an example. This is not limited in this specification.

607: The transmit end sends a third LDPC codeword with a third code rate. A set of punctured check bits of the third LDPC codeword is a subset of a set of punctured check bits of the second LDPC codeword.

It may be understood that the second LDPC code with the second code rate is not successfully decoded by the receive end. In a retransmission case, a code rate is usually reduced, to increase a probability of successful decoding by the receive end. Therefore, in an example, a code rate (namely, the third code rate) of the third LDPC code is lower than the second code rate.

In addition, in the IR-HARQ scenario, a puncturing pattern corresponding to a high code rate is compatible with a puncturing pattern corresponding to a low code rate. In other words, the puncturing pattern corresponding to the high code rate includes the puncturing pattern corresponding to the low code rate, that is, a puncturing position set of a codeword with a low code rate includes a puncturing position set of a codeword with a high code rate.

The transmit end first sends the second LDPC codeword with a high code rate. If the receive end does not correctly decode all the system bits of the second LDPC codeword, the transmit end may retransmit the punctured check bits of the second LDPC codeword. A specific quantity of the retransmitted check bits may be determined according to a transmission requirement, for example, may be determined based on a new code rate required for retransmission, a new quantity of channel resources allocated for retransmission, or the like. As an example, it is assumed that the transmit end retransmits t punctured check bits.

In an embodiment, during retransmission, the transmit end may send only punctured check bits. For example, the t check bits may be the first t check bits in all punctured check bits of the first LDPC codeword that are sorted in descending order of confidences.

It is assumed that a priority order of check bits of a mother code whose code length is N is shown in descending order as follows:

$\{t_1, t_2, ..., t_i, ...\}$, where $t_i$ represents an index of a column that corresponds to a check bit and that is in the check matrix of the mother code, and $t_i$ is an integer.

In this embodiment of this application, a higher confidence of a check bit indicates a higher priority of puncturing the check bit during rate matching. Therefore, the t check bits may be check bits in the first t positions selected based on a priority order of $\{t_1, t_2, ..., t_i, ...\}$ in descending order of priorities.

In another embodiment, during retransmission, the transmit end may send a part of punctured check bits and system bits. This is not limited in this specification.

The receive end receives a second channel receiving sequence from the transmit end.

608: The receive end pads, with zeros based on the priority order of the check bits of the mother code of the LDPC code, corresponding positions of a second LLR sequence corresponding to the second channel receiving sequence, and then decodes a combined sequence of the second LLR sequence that is padded with zeros and the first LLR sequence that is padded with zeros.

The combined sequence is obtained by combining the second LLR sequence that is padded with zeros and the first LLR sequence that is padded with zeros. Specifically, the second LLR sequence that is padded with zeros and the first LLR sequence that is padded with zeros are combined bitwise. LLR values at a same bit position in the second LLR sequence that is padded with zeros and the first LLR sequence that is padded with zeros are combined, and LLR values at different bit positions are retained.

For example, a length of the first LLR sequence that is padded with zeros is 6, index positions are 1, 2, 3, 4, and 5, and LLR values corresponding to the index positions are respectively $LLR_{11}$, $LLR_{12}$, $LLR_{13}$, $LLR_{14}$, and $LLR_{15}$. A length of the second LLR sequence that is padded with zeros is 6, index positions are 3, 4, 5, 6, and 7, and LLR values corresponding to the index positions are respectively $LLR_{23}$, $LLR_{24}$, $LLR_{25}$, $LLR_{26}$, and $LLR_{27}$. Therefore, the combined sequence is $\{LLR_{11}, LLR_{12}, LLR_{13}+LLR_{23}, LLR_{14}+LLR_{24}, LLR_{15}+LLR_{25}, LLR_{26}, LLR_{27}\}$, where addition of the LLR values is binary addition.

In this embodiment of this application, that the receive end performs combination based on the LLR sequence is merely used as an example. A person skilled in the art may figure out another equivalent change or processing. For example, it is also feasible for the receive end to combine soft information obtained through demodulation. This may specifically depend on a decoding mechanism of the receive end.

In a case, when the receive end successfully obtains all the system bits through decoding based on the combined sequence, the receive end outputs the decoding result, as shown in step 609.

In another case, the receive end still fails to obtain, based on the combination sequence, the system bits through decoding. The receive end may request the transmit end to perform next retransmission, until the receive end successfully obtains the system bits through decoding, or until a specified maximum quantity of retransmissions is reached, then the receive end determines that decoding fails, as described in step 610.

Specifically, during initial transmission, when the receive end fails to restore the system bits, the transmit end may retransmit, in descending order of confidences, the check bits that have been punctured. For example, in the first retransmission, the transmit end may retransmit, in descending order of priorities, $n_1$ check bits that have been punctured during the initial transmission and that have highest priorities. If the receive end still fails to perform decoding, the transmit end retransmits, in descending order of priorities, $n_2$ check bits that have been punctured and that have second highest priorities. The rest may be deduced by analogy until all punctured check bits are sent. It may be understood that, in this process, a code rate continuously decreases. When the transmit end retransmits all punctured check bits, if the receive end still cannot correctly decode the system bits, it indicates that the data packet fails to be transmitted.

It can be learned from the foregoing retransmission process that a code rate of an $l^{th}$ retransmission may meet the following relationship:

$$R_c = \frac{k}{n} \leq R_e = \frac{k}{n - n_{cp} + \sum_{i=0}^{l} t_i} \leq R'_c = \frac{k}{n - n_{cp}} \tag{4}$$

In formula (4), $R'_c$ is a code rate of an LDPC codeword sent by the transmit end for the first time, a redundancy amount increased for the first time is $t_0 = 0$, k represents a quantity of system bits, $n_{cp}$ represents a total quantity of punctured check bits, and n represents a length of the mother code.

The foregoing describes in detail the rate matching process and the decoding process of the receive end provided in this application. The following describes application of the method in IR-HARQ by using an example.

In an example, the transmit end and the receive end store information about the priority order of the check bits of the mother code of the LDPC code.

It is assumed that the priority order of the check bits of the mother code is $\{t_1, t_2, ..., t_i, ...\}$ in descending order, where $t_i$ is an integer. It should be understood that the priority order is represented by using a column index of the check part of the check matrix of the mother code.

Initial IR-HARQ transmission is performed, and the transmit end may determine, based on a code rate required for the initial IR-HARQ transmission, a quantity L of check bits that need to be punctured. The transmit end selects the first L check bits in the priority order based on the quantity L of check bits that need to be punctured and based on the priority order of the check bits in descending order, and records respective positions of the L check bits. After completing the LDPC encoding, the transmit end performs rate matching. Specifically, the transmit end punctures the L check bits of the LDPC codeword output through encoding, and then sends the L check bits.

During the initial transmission, an LDPC codeword with a high code rate is obtained through puncturing, for example, the code rate is 5/6.

For the initial IR-HARQ transmission, the receive end determines, based on a current target code length, a current target code rate, and a quantity L of to-be-punctured bits and in the priority order of the check bits of the mother code, respective positions (namely, indexes) of the first L check bits sorted in descending order of priorities, and performs LDPC decoding after the positions corresponding to the L check bits are padded with zeros.

If the initial IR-HARQ transmission fails, that is, if the receive end fails to decode all the system bits, retransmission in an IR-HARQ mechanism is performed.

If IR-HARQ retransmission is performed, the transmit end may determine, based on a code rate required for retransmission or based on a quantity of channel resources allocated for retransmission, a quantity P of bits that need to be punctured for retransmission, where P is an integer.

It may be understood that, to improve a decoding success rate of the receive end, the code rate is usually reduced for retransmission. Therefore, the code rate used for retransmission is usually lower than a code rate used for initial transmission. In other words, the quantity P of bits that need to be punctured in retransmission is less than a quantity N of bits that need to be punctured in the initial transmission.

For ease of description, it is assumed that a code rate used in first retransmission is $R_1$.

When performing the first retransmission, the transmit end may send the first $n_1$ check bits in the L check bits punctured during the initial transmission in descending order of priorities, where $n_1$ is an integer. That is, priorities of the $n_1$ check bits are not lower than priorities of check bits other than the $n_1$ check bits in the L check bits.

The transmit end sends the $n_1$ check bits.

The receive end receives the $n_1$ check bits, combines a sequence corresponding to the $n_1$ check bits and a sequence received during the initial transmission into one sequence, and then decodes the combined sequence.

If the receive end successfully decodes all the system bits based on the combined sequence, the decoding succeeds.

If the receive end still fails to restore all the system bits based on the combined sequence, and the maximum quantity of retransmissions is not reached, next retransmission is performed.

When performing second retransmission, the transmit end may send $n_2$ check bits with higher priorities other than the $n_1$ check bits in the L check bits punctured during the initial transmission, where $n_2$ is an integer.

Specifically, the transmit end may select the $n_2$ check bits in descending order of priorities from remaining check bits other than the $n_1$ check bits in the L check bits punctured during the initial transmission.

The transmit end sends the $n_2$ check bits.

The receive end receives the $n_2$ check bits, combines a sequence corresponding to the $n_2$ check bits, the sequence corresponding to the $n_1$ check bits, and the sequence received during the initial transmission into one sequence, and then decodes the combined sequence.

The rest may be deduced by analogy until the transmit end sends all the punctured check bits during the initial transmission. In this case, if the receive end still cannot correctly restore the system bits, it indicates that the data packet fails to be transmitted, and the transmission ends.

It can be learned from the foregoing process that, when selecting a check bit that needs to be punctured during the initial transmission, the transmit end preferentially selects a check bit with a high priority to perform puncturing, that is, preferentially punctures a check bit with a high confidence (or not easily affected by noise, or insensitive to noise). During retransmission, a check bit with a high priority in punctured check bits is preferentially retransmitted. The transmit end follows such a puncturing and retransmission principle, so that a probability of successful decoding by the receive end can be increased.

In addition, because a success rate of decoding by the receive end is improved, a quantity of retransmissions is reduced, and a retransmission delay is reduced.

The transmit end continuously fills punctured check bits, so that the code rate continuously decreases, for example, gradually decreases from 5/6 to 3/4, 2/3, 1/2, or the like. This can meet a requirement of increasing a redundant bit through retransmission in the IR-HARQ mechanism to reduce a channel coding rate, and can improve decoding performance.

The foregoing describes in detail a process in which the receive end performs rate matching on the receive end and a decoding process of the receive end with reference to FIG. 1 to FIG. 9. The following provides BER performance comparison between the confidence-based puncturing scheme provided in embodiments of this application and a puncturing scheme in the 802.11ac standard.

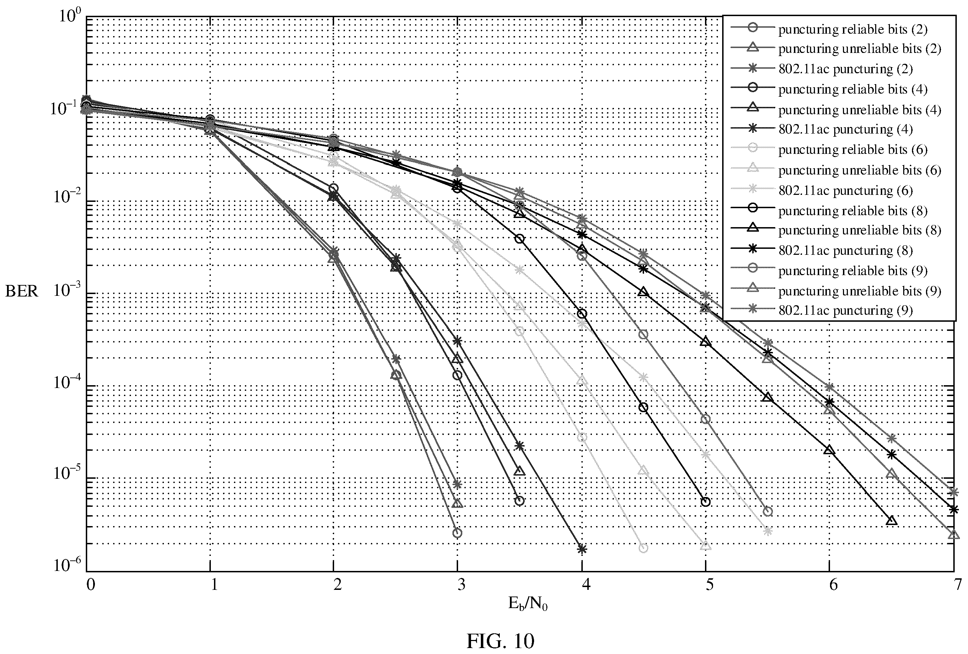

FIG. 10 to FIG. 19 show comparison between BER performance curves of a confidence-based puncturing scheme provided in this application and a conventional puncturing scheme for various quantities of to-be-punctured check bits.

Simulation parameters in FIG. 10 to FIG. 19 are set as follows: AWGAN channel; BPSK modulation; log-SPA decoding; a maximum quantity of iterative decoding times is 10; a stop-wait retransmission request policy is used; and a maximum quantity of transmissions for restoring data of each frame is 4.

In addition, performance evaluation parameters considered in FIG. 10 to FIG. 19 are mainly a frame error rate (frame error rate, FER) and throughput (throughput). Throughput = (Quantity of correctly received frames $\times$ k)/Total quantity of sent bits. k is a quantity of information bits of each frame. In addition, $E_b/N_0$ in the foregoing figures represents a bit error rate, and $E_s/N_0$ represents a symbol signal-to-noise ratio. A QC-LDPC code whose code length is 1944 or 972 in the 802.11ac standard is used for the mother code.

Specifically, FIG. 10 shows BER performance comparison between a confidence-based puncturing scheme provided in this application and a conventional puncturing scheme (a mother code length is 1944) for various quantities of to-be-punctured check bits.

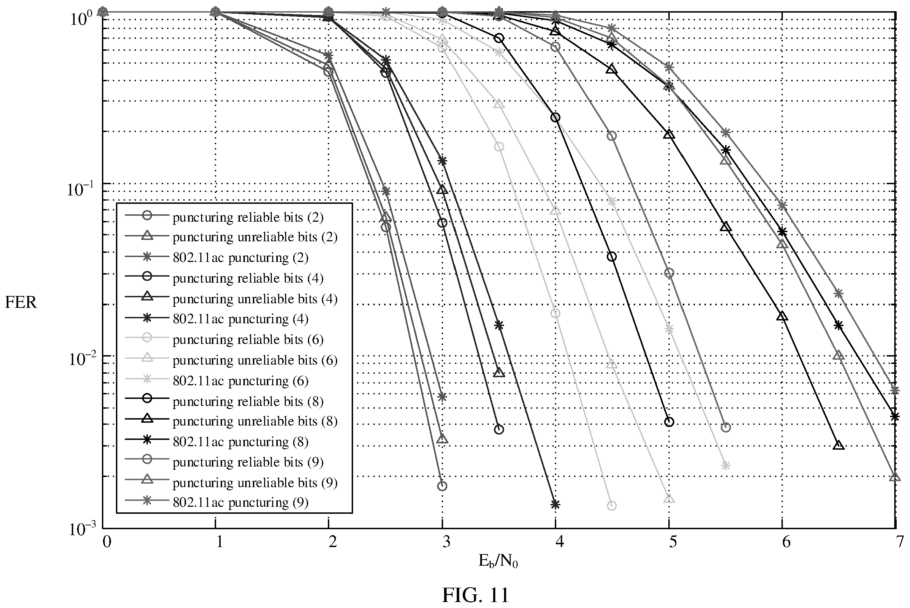

FIG. 11 shows BER performance comparison between a confidence-based puncturing scheme provided in this application and a conventional puncturing scheme (a mother code length is 1296) for various quantities of to-be-punctured check bits.

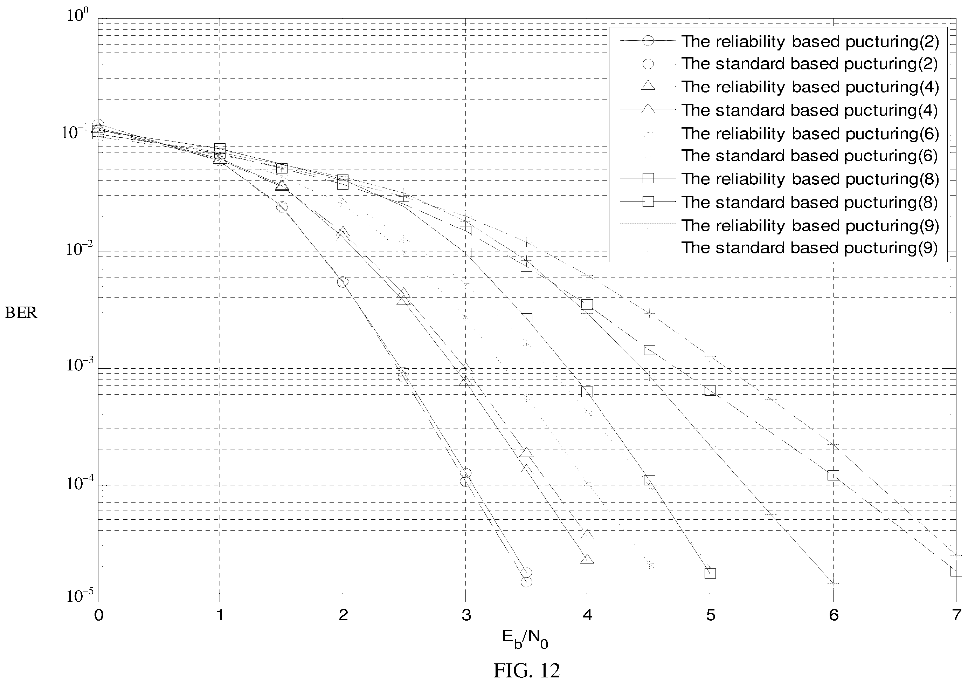

FIG. 12 shows BER performance comparison between a confidence-based puncturing scheme provided in this application and a conventional puncturing scheme (a mother code length is 648) for various quantities of to-be-punctured check bits.

In legends in FIG. 10 to FIG. 12, "puncturing reliable bits", that is, puncturing reliable bits, represents a puncturing scheme in which a reliable check bit (that is, with a high confidence) is preferentially punctured based on a confidence provided in this application; "802.11 ac puncturing" represents a puncturing scheme in the 802.11ac standard, and is also referred to as a conventional puncturing scheme in this specification; and "puncturing unreliable bits", that is, puncturing unreliable bits, represents a scheme in which an unreliable check bit (that is, with a low confidence) is preferentially punctured based on a confidence. A number in brackets indicates a quantity of punctured bits, and corresponds to quantities of punctured bits when two columns, four columns, six columns, eight columns, and nine columns are punctured, as shown in Table 2.

It may be found that, for a same $E_s/N_0$, an FER of the confidence-based puncturing scheme provided in this application is lower, and it indicates that the confidence-based puncturing scheme provided in this application has better performance than the conventional puncturing scheme.

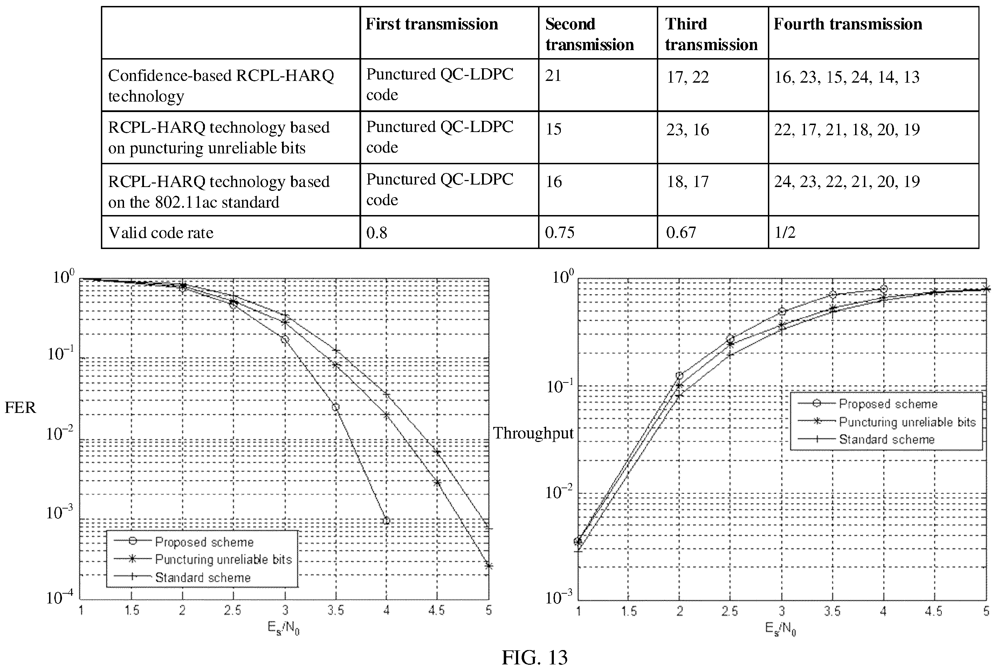

FIG. 13 shows an application example of a puncturing scheme of an LDPC code whose maximum quantity of retransmissions is 3 and whose mother code length is 1944 in an IR-HARQ mechanism.

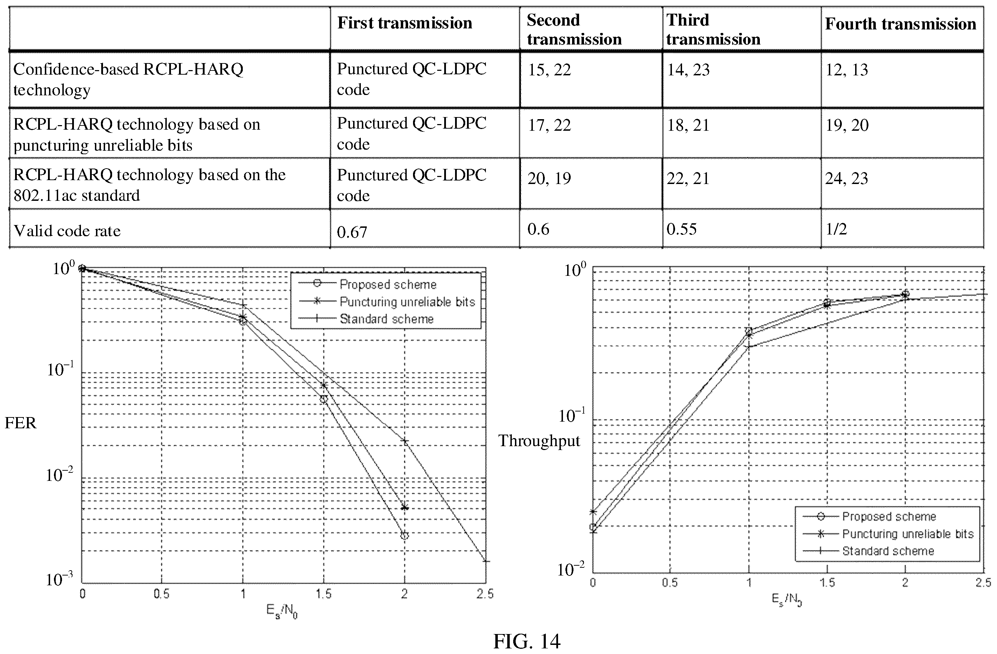

FIG. 14 shows another application example of a puncturing scheme of an LDPC code whose maximum quantity of retransmissions is 3 and whose mother code length is 1944 in an IR-HARQ mechanism.

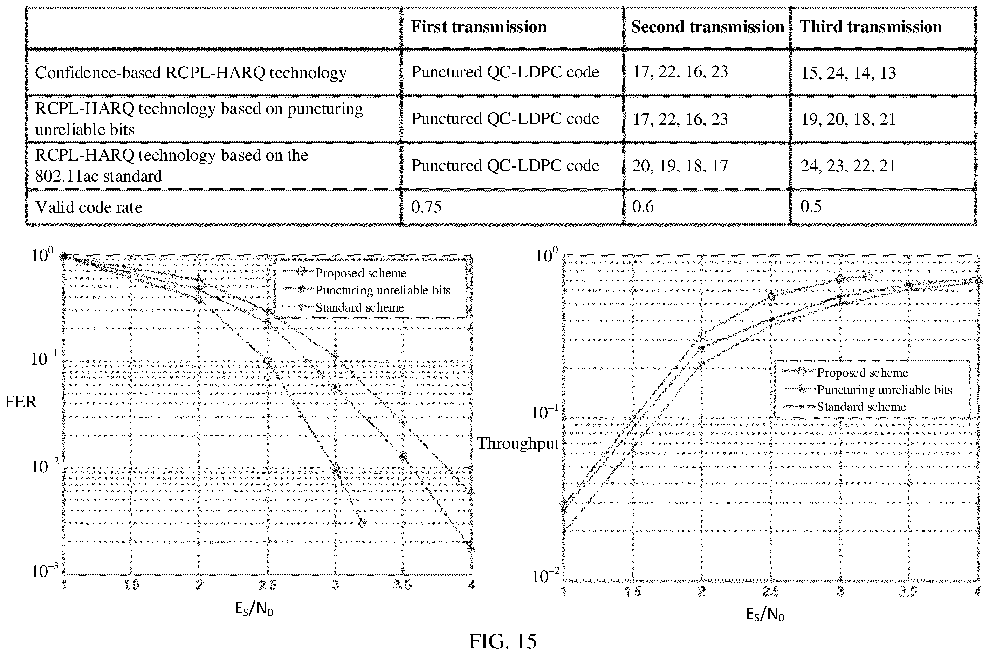

FIG. 15 shows another application example of a puncturing scheme of an LDPC code whose maximum quantity of retransmissions is 2 and whose mother code length is 1944 in an IR-HARQ mechanism.

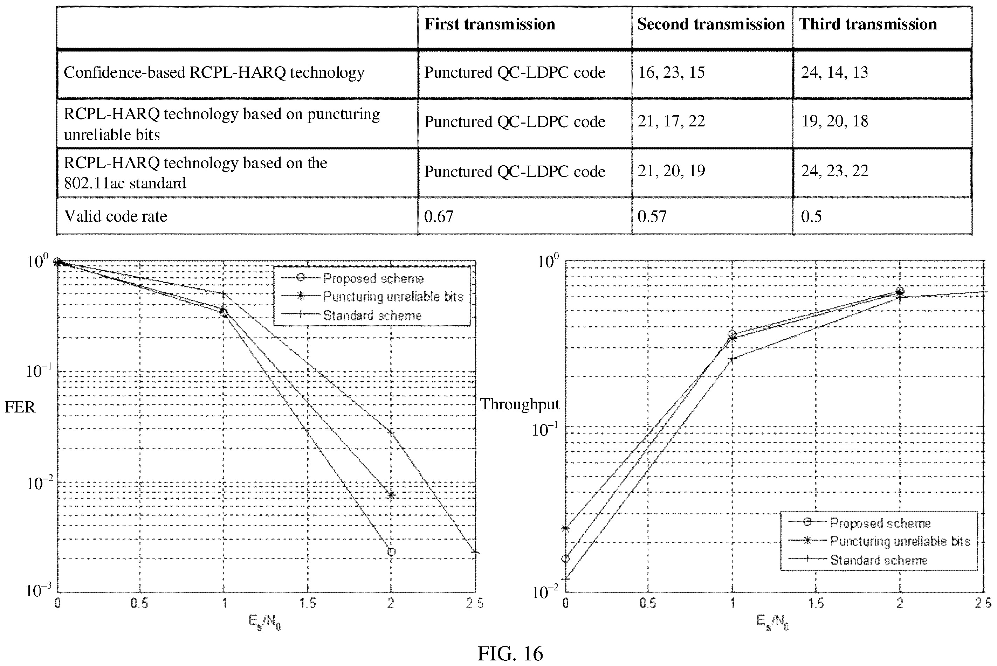

FIG. 16 shows another application example of a puncturing scheme of an LDPC code whose maximum quantity of retransmissions is 2 and whose mother code length is 1944 in an IR-HARQ mechanism.

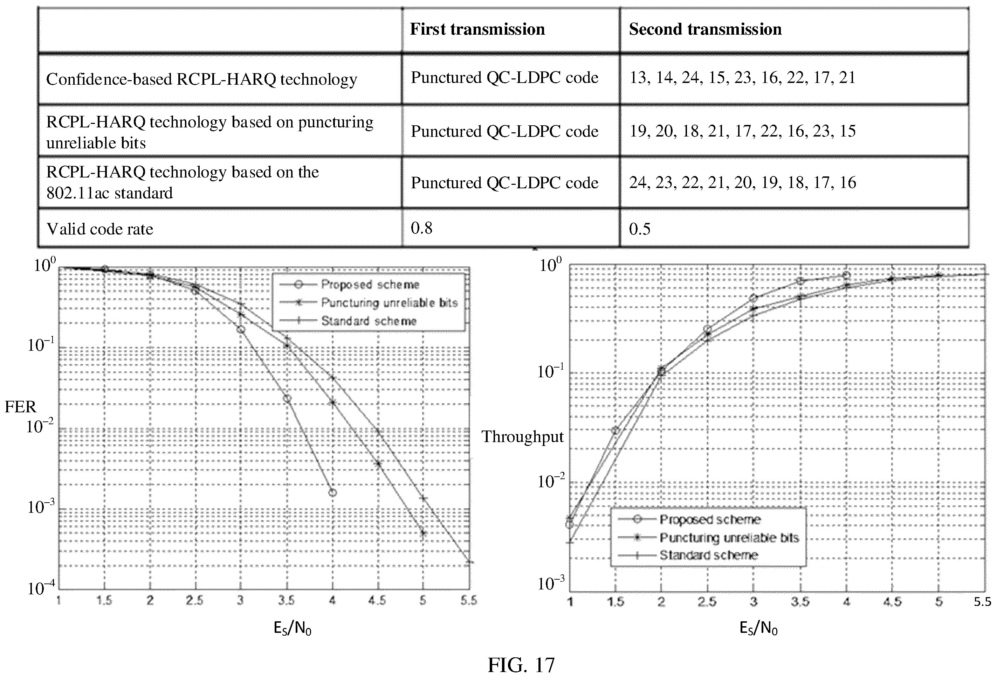

FIG. 17 shows another application example of a puncturing scheme of an LDPC code whose maximum quantity of retransmissions is 1 and whose mother code length is 1944 in an IR-HARQ mechanism.

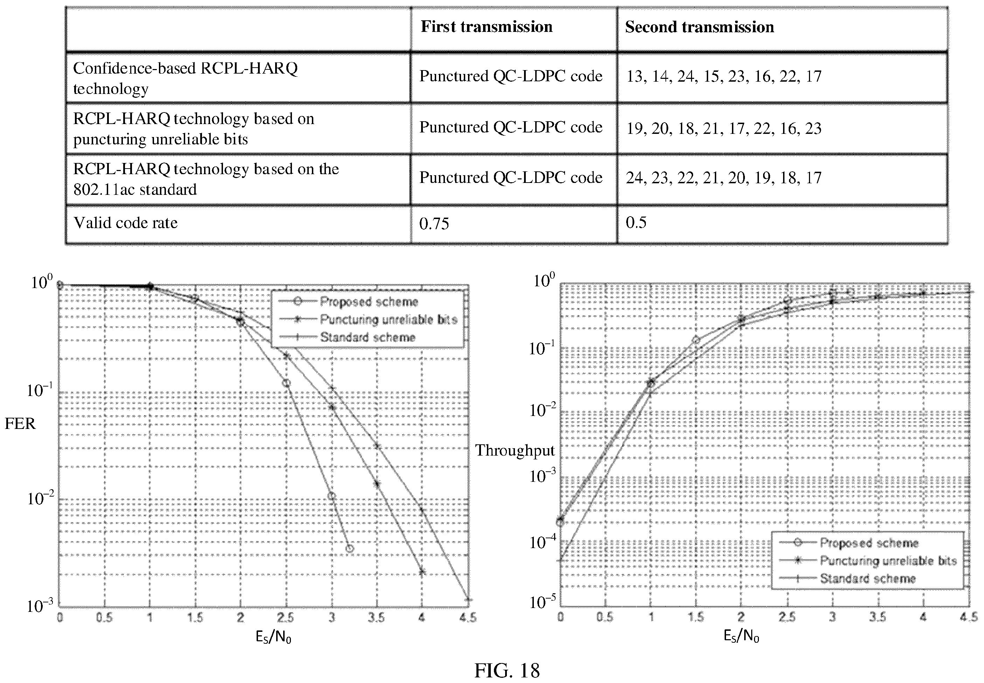

FIG. 18 shows another application example of a puncturing scheme of an LDPC code whose maximum quantity of retransmissions is 1 and whose mother code length is 1944 in an IR-HARQ mechanism.

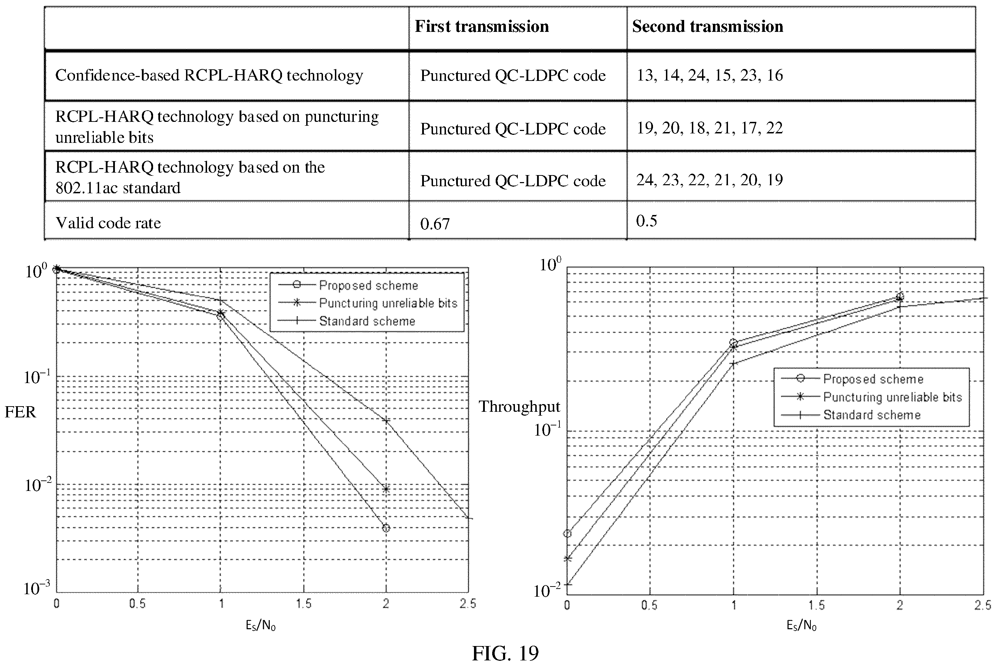

FIG. 19 shows an application example of a puncturing scheme of an LDPC code whose maximum quantity of retransmissions is 1 and whose mother code length is 1944 in an IR-HARQ mechanism.

In the legends in FIG. 13 to FIG. 19, "proposed scheme" represents the confidence-based puncturing scheme proposed in this application, "standard scheme" represents a standard (namely, the 802.11ac standard in the foregoing) puncturing scheme, and "puncturing unreliable bits" represents a puncturing scheme in which unreliable check bits are punctured, and this corresponds to a puncturing scheme of a middle row in Table 2.

It can be learned from FIG. 13 to 19 that, for a same $E_s/N_0$, the confidence-based puncturing scheme provided in this application has a lower FER and a higher throughput. It indicates that the confidence-based puncturing scheme provided in this application in which a check bit with a high confidence is preferentially punctured has better performance than the conventional puncturing scheme, and also has better performance than a puncturing scheme in which a check bit with a low confidence is preferentially punctured.

The following describes communication apparatuses in this application.

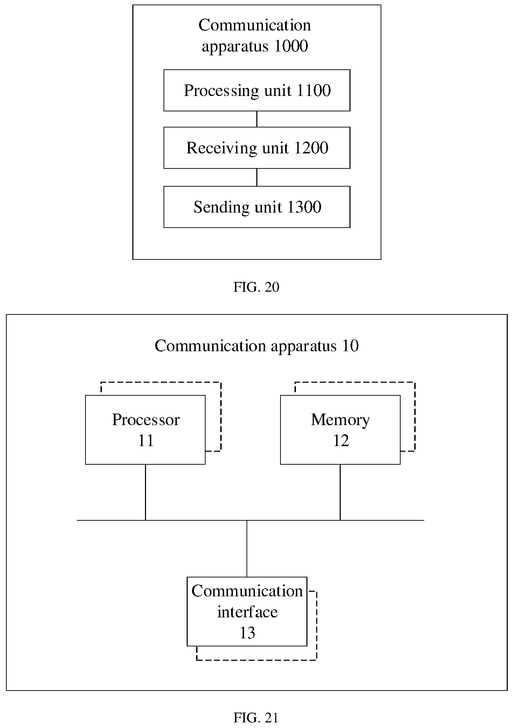

FIG. 20 is a block diagram of a communication apparatus 1000 according to this application. As shown in FIG. 20, the communication apparatus 1000 includes a processing unit 1100, a receiving unit 1200, and a sending unit 1300.

Optionally, the communication apparatus 1000 may correspond to the transmit end in the method embodiments.

In this case, units of the communication apparatus 1000 have the following functions.

The processing unit 1100 is configured to perform rate matching on a first low-density parity-check LDPC codeword with a first code rate based on a priority order of check bits of a mother code of an LDPC code, to obtain a second LDPC codeword with a second code rate. The priority order indicates a priority order of puncturing the check bits of the mother code during rate matching, the priority order is related to confidences of the check bits, and the confidences of the check bits indicate degrees to which the check bits are affected by noise in a channel transmission process.

The sending unit 1300 is configured to send the second LDPC codeword.

Optionally, in an embodiment, the processing unit 1100 is further configured to:
select, for puncturing and based on a quantity L of to-be-punctured bits and the priority order of the check bits of the mother code, L check bits in the first LDPC codeword. The priority order is a descending order of the confidences of the check bits, and the L check bits are the first L check bits in the priority order. $L \geq 1$, and L is an integer.

Optionally, in an embodiment, a check matrix of the mother code includes a check part, the check part includes a column that corresponds to a check bit and that is in the check matrix, and the priority order indicates a priority order of columns included in the check part. Each of the columns included in the check part corresponds to z check bits of the mother code, $z = N/n$, N is a code length of the mother code, and n represents a total quantity of columns included in the check matrix of the mother code.

Optionally, in an embodiment, the code length of the mother code is 1944, a code rate is 1/2, the check part is a 13th column to a 24th column in the check matrix of the mother code, and a descending order of priorities of the 13th column to the 24th column is as follows:
13, 14, 24, 15, 23, 16, 22, 17, 21, 18, 20, 19.

Optionally, in an embodiment, the code length of the mother code is 1296, a code rate is 1/2, the check part is a 13th column to a 24th column in the check matrix of the mother code, and a descending order of priorities of the 13th column to the 24th column is as follows:
13, 17, 22, 18, 24, 16, 23, 19, 14, 21, 15, 20.

Optionally, in an embodiment, the code length of the mother code is 648, a code rate is 1/2, the check part is a 13th column to a 24th column in the check matrix of the mother code, and a descending order of priorities of the 13th column to the 24th column is as follows:
13, 17, 16, 20, 24, 14, 19, 18, 23, 22, 15, 21.

Optionally, in an embodiment, priorities of z check bits corresponding to any column included in the check part are the same.

Optionally, in an embodiment,
the L check bits in the first LDPC codeword meet one of the following:

if $L < z$, the L check bits in the first LDPC codeword are L check bits in z check bits corresponding to a highest-priority column in the columns included in the check part, where z is a positive integer; or

if $L > z$, the L check bits in the first LDPC codeword are L check bits in tz check bits corresponding to t columns in the columns included in the check part, where the t columns are the first t columns in the columns included in the check part that are sorted in descending order of priorities, the L check bits include z(t-1) check bits corresponding to the first t-1 columns in the t columns and p check bits in a tth column, the p check bits are any p check bits in z check bits corresponding to the tth column, both t and p are positive integers, and $p \leq z$; or

if $L = mz$, the L check bits in the first LDPC codeword are mz check bits corresponding to m columns in the columns included in the check part, where the m columns are the first m columns in the columns included in the check part that are sorted in descending order of priorities, $m \geq 1$, and m is an integer.

Optionally, in an embodiment, the receiving unit 1200 is further configured to receive retransmission indication information.

The processing unit 1100 is further configured to perform rate matching on a to-be-retransmitted codeword based on the priority order of the check bits of the mother code, to obtain a third LDPC codeword with a third code rate. The to-be-retransmitted codeword is obtained by performing LDPC encoding on to-be-retransmitted bits, and a puncturing position set of check bits of the third LDPC codeword is a proper subset of a puncturing position set of check bits of the second LDPC codeword.

The sending unit 1300 is further configured to send the third codeword.

Optionally, in the foregoing implementations, the receiving unit 1200 and the sending unit 1300 may alternatively be integrated into one transceiver unit or one input/output unit, and have both receiving and sending functions. This is not limited herein.

Optionally, the communication apparatus 1000 may be a transmit-end device, or the communication apparatus 1000 may be a component, a module, or the like that is inside the transmit-end device and that has a function of implementing each method embodiment, for example, an encoder.

In an implementation, the communication apparatus 1000 is a transmit end in the foregoing method embodiments, and the communication apparatus 1000 may have any function of the transmit end in the method embodiments. In this case, the processing unit 1100 may be a processor. The receiving unit 1200 and the sending unit 1300 may be a transceiver. The transceiver may specifically include a receiver and a transmitter. The receiver is configured to execute a receiving function, and the transmitter is configured to execute a transmitting function.

Optionally, in another implementation, the communication apparatus 1000 may be a circuit system in a transmit-end device. In this case, the processing unit 610 may be a chip, a logic circuit, an integrated circuit, a processing circuit, a system-on-a-chip (system on a chip, SoC) chip, or the like. The transceiver unit 620 may be a communication interface, and the communication interface may be an interface circuit, an input/output interface, or the like.

In an embodiment, the communication apparatus 1000 may be an encoder in a transmit-end device.

In the foregoing embodiments, a function of the processing unit 1100 may be implemented by hardware, or may be implemented by hardware executing corresponding software.

For example, the processing unit 1100 may include one or more processors. The one or more processors are configured to read and execute a computer program or instructions stored in a memory, so that a device on which the communication apparatus 1000 is installed performs operations and/or processing performed by the transmit end in the method embodiments of this application. The memory is located outside the one or more processors.

Further, the processing unit 1100 may further include one or more memories, and the one or more processors and the one or more memories are connected by using a circuit/wire. The one or more processors read the computer program or the instructions stored in the one or more memories, so that a device on which the communication apparatus 1000 is installed performs operations and/or processing performed by the transmit end in the method embodiments of this application.

For another example, the processing unit 1100 is a processor, and the receiving unit 1200 and the sending unit 1300 may be an interface circuit. The interface circuit is configured to receive computer code or instructions, and transmit the computer code or the instructions to the processor. The processor executes the computer code or the instructions, so that a device on which the communication apparatus 1000 is installed performs operations and/or processing performed by the transmit end in the method embodiments of this application. Optionally, the receiving unit 1200 and the sending unit 1300 may be different interface circuits, or may alternatively be different functions of a same interface circuit. This is not limited.

Optionally, the communication apparatus 1000 may correspond to the receive end in the method embodiments.

In this case, units of the communication apparatus 1000 have the following functions.

The receiving unit 1200 is configured to receive a first channel receiving sequence.

The processing unit 1100 pads, with zeros based on a priority order of check bits of a mother code of an LDPC code, corresponding positions of a first LLR sequence corresponding to the first channel receiving sequence, and decodes the first LLR sequence that is padded with zeros. The corresponding positions of the first LLR sequence are positions of check bits punctured in a rate matching process of an LDPC codeword corresponding to the first channel receiving sequence, the priority order of the check bits is related to confidences of the check bits, and the confidences of the check bits indicate degrees to which the check bits are affected by noise in a channel transmission process.

The sending unit 1300 is further configured to send a retransmission request to the transmit end if the processing unit 1100 fails to decode the LDPC codeword.

Optionally, in an embodiment, the check bits punctured in the rate matching process of the LDPC codeword corresponding to the first channel receiving sequence are the first L check bits that are in the check bits of the mother code corresponding to the LDPC codeword and that are sorted in descending order of priorities. L is a quantity of to-be-punctured check bits, and L is an integer.

Optionally, in an embodiment, a check matrix of the mother code includes a check part, the check part includes a column that corresponds to a check bit and that is in the check matrix, and the priority order indicates a priority order of columns included in the check part. Each of the columns included in the check part corresponds to z codeword bits of the mother code, $z = N/n$, N represents a code length of the mother code, n represents a total quantity of columns included in the check matrix of the mother code, and N and n are integers.

Optionally, in an embodiment, a length of the mother code is 1944, a code rate is 1/2, the check part is a 13th column to a 24th column in the check matrix of the mother code, and a descending order of priorities of the 13th column to the 24th column is as follows:

13, 14, 24, 15, 23, 16, 22, 17, 21, 18, 20, 19.

Optionally, in an embodiment, a length of the mother code is 1296, a code rate is 1/2, the check part is a 13th

column to a 24th column in the check matrix of the mother code, and a descending order of priorities of the 13th column to the 24th column is as follows:

13, 17, 22, 18, 24, 16, 23, 19, 14, 21, 15, 20.

Optionally, in an embodiment, a length of the mother code is 648, a code rate is 1/2, the check part is a 13th column to a 24th column in the check matrix of the mother code, and a descending order of priorities of the 13th column to the 24th column is as follows:

13, 17, 16, 20, 24, 14, 19, 18, 23, 22, 15, 21.

Optionally, in an embodiment, priorities of z codeword bits corresponding to any column included in the check part are the same.

Optionally, in an embodiment, the L check bits punctured in the rate matching process of the LDPC codeword corresponding to the first channel receiving sequence meet one of the following cases:

if $L < z$, the L punctured check bits are any L check bits in z check bits corresponding to a highest-priority column in the columns included in the check part; or

if $L > z$, the L punctured check bits are L check bits in tz check bits corresponding to t columns in the columns included in the check part, where the t columns are the first t columns in the columns included in the check part that are sorted in descending order of priorities, the L check bits include z(t-1) check bits corresponding to the first t-1 columns in the t columns and p check bits in a $t^{th}$ column, the p check bits are any p check bits in z check bits corresponding to the $t^{th}$ column, both t and p are positive integers, and $p \leq z$; or

if $L = mz$, the L punctured check bits are mz check bits corresponding to m columns included in the check part, where the m columns are the first m columns in the columns included in the check part that are sorted in descending order of priorities.

Optionally, in an embodiment, the sending unit 1300 is further configured to send retransmission indication information to the transmit end.

The receiving unit 1200 is further configured to receive a second channel receiving sequence.

The processing unit 1100 is further configured to: pad, with zeros based on the priority order of the check bits of the mother code, corresponding positions in a second LLR sequence corresponding to the second channel receiving sequence, and decode a combined sequence of the second LLR sequence that is padded with zeros and the first LLR sequence that is padded with zeros. A set including positions that need to be padded with zeros in the second LLR sequence is a proper subset of a set including positions that need to be padded with zeros in the first LLR sequence.

In the foregoing implementations, the receiving unit 1200 and the sending unit 1300 may alternatively be integrated into one transceiver unit or one input/output unit, and have both receiving and sending functions. This is not limited herein.

Optionally, the communication apparatus 1000 may be a receive end, or the communication apparatus 1000 may be a component, a module, or the like that is inside the receive end and that has a function of implementing each method embodiment, for example, a decipherer (or a decoder).

In an implementation, the communication apparatus 1000 is the receive end in the foregoing method embodiments, and the communication apparatus 1000 may have any function of the receive-end device in the method embodiments. In this case, the processing unit 1100 may be a processor, and the receiving unit 1200 and the sending unit 1300 may be a transceiver. The transceiver may specifically include a receiver and a transmitter. The receiver is configured to execute a receiving function, and the transmitter is configured to execute a transmitting function.

In another implementation, the communication apparatus 1000 may be a circuit system of the receive end. In this case, the processing unit 1100 may be a chip, a logic circuit, an integrated circuit, a processing circuit, an SoC chip, or the like. The receiving unit 1200 and the sending unit 1300 may be a communication interface. The communication interface may be an interface circuit, an input/output interface, or the like. Optionally, the receiving unit 1200 and the sending unit 1300 may be different interface circuits, or may be different functions of a same interface circuit. This is not limited.

In an embodiment, the communication apparatus 1000 may be a decipherer in a receive-end device.

In the foregoing embodiments, a function of the processing unit 1100 may be implemented by hardware, or may be implemented by hardware executing corresponding software.

For example, the processing unit 1100 may include one or more processors. The one or more processors are configured to read and execute a computer program or instructions stored in a memory, so that a device on which the communication apparatus 1000 is installed performs operations and/or processing performed by the receive end in the method embodiments of this application. The memory is located outside the one or more processors.

Further, the processing unit 1100 may further include one or more memories, and the one or more processors and the one or more memories are connected by using a circuit/wire. The one or more processors read the computer program or the instructions stored in the one or more memories, so that a device on which the communication apparatus 1000 is installed performs operations and/or processing performed by the receive end in the method embodiments of this application.

For another example, the processing unit 1100 is a processor, and the receiving unit 1200 and the sending unit 1300 are an interface circuit. The interface circuit is configured to receive computer code or instructions, and transmit the computer code or the instructions to the processor. The processor executes the computer code or the instructions, so that a device on which the communication apparatus 1000 is installed performs operations and/or processing performed by the receive end in the method embodiments of this application.

FIG. 21 is a diagram of a structure of a communication apparatus 10 according to this application. As shown in FIG. 21, the communication apparatus 10 includes one or more processors 11, one or more memories 12, and one or more communication interfaces 13. The processor 11 is configured to control the communication interface 13 to send and receive a signal. The memory 12 is configured to store a computer program. The processor 11 is configured to invoke the computer program from the memory 12 and run the computer program, so that the communication apparatus 10 performs processing performed by the transmit end or the receive end in the method embodiments of this application.

In FIG. 21, a dashed box behind a component (for example, the processor, the memory, or the communication interface) indicates that there may be at least one component.

Optionally, the memory and the processor in the foregoing apparatus embodiments may be physically independent units, or the memory and the processor may be integrated together.

In addition, this application further provides a computer-readable storage medium. The computer-readable storage medium stores computer instructions. When the computer instructions are run on a computer, operations and/or processing performed by the transmit end in the rate matching method provided in this application are/is performed.

This application further provides a computer-readable storage medium. The computer-readable storage medium stores computer instructions. When the computer instructions are run on a computer, the computer is enabled to perform operations and/or processing performed by the receive end in the decoding method provided in this application.

This application further provides a computer program product. The computer program product includes computer code or instructions. When the computer code or the instructions are run on a computer, the rate matching method in the method embodiments of this application is implemented.

This application further provides a computer program product. The computer program product includes computer code or instructions. When the computer code or the instructions are run on a computer, the decoding method in the method embodiments of this application is implemented.

This application further provides a communication apparatus, including a processor and an interface circuit. The interface circuit is configured to receive computer code or instructions, and transmit the computer code or the instructions to the processor, and the processor is configured to run the computer code or the instructions, so that operations and/or processing performed by the transmit end in the rate matching method provided in this application is performed.

This application further provides a communication apparatus, including a processor and an interface circuit. The interface circuit is configured to receive computer code or instructions, and transmit the computer code or the instructions to the processor, and the processor is configured to run the computer code or the instructions, so that operations and/or processing performed by the receive end in the decoding method provided in this application is performed.

This application further provides a chip. The chip includes one or more processors. The one or more processors are configured to execute a computer program stored in a memory, to perform operations and/or processing performed by the transmit end in any method embodiment. The memory is disposed independent of the chip.

Further, the chip may further include one or more communication interfaces. The one or more communication interfaces may be an input/output interface, an interface circuit, or the like. Further, the chip may further include one or more memories.

This application further provides a chip. The chip includes one or more processors. The one or more processors are configured to execute a computer program stored in a memory, to perform operations and/or processing performed by the receive-end device in any method embodiment. The memory is disposed independent of the chip.

Further, the chip may further include one or more communication interfaces. The one or more communication interfaces may be an input/output interface, an interface circuit, or the like. Further, the chip may further include one or more memories.

This application further provides a wireless communication system, including the transmit end and the receive end in embodiments of this application.

Optionally, one of the transmit end and the receive end is a network device (for example, a base station), and the other is a terminal device.

A processor in embodiments of this application may be an integrated circuit chip, and has a signal processing capability. In an implementation process, the steps in the foregoing method embodiments are implemented by using a hardware integrated logic circuit in the processor, or by using instructions in a form of software. The processor may be a general-purpose processor, a digital signal processor (digital signal processor, DSP), an application-specific integrated circuit (application-specific integrated circuit, ASIC), a field programmable gate array (field programmable gate array, FPGA) or another programmable logic device, a discrete gate or a transistor logic device, or a discrete hardware component. The general-purpose processor may be a microprocessor, or the processor may be any conventional processor or the like. The steps of the methods disclosed in embodiments of this application may be directly presented as being performed and completed by a hardware encoding processor, or performed and completed by a combination of hardware and a software module in an encoding processor. The software module may be located in a mature storage medium in the art, such as a random access memory, a flash memory, a read-only memory, a programmable read-only memory, an electrically erasable programmable memory, or a register. The storage medium is located in the memory, and the processor reads information in the memory and completes the steps in the foregoing methods in combination with hardware of the processor.

A memory in the embodiments of this application may be a volatile memory or a non-volatile memory, or may include both a volatile memory and a non-volatile memory. The non-volatile memory may be a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), or a flash memory. The volatile memory may be a random access memory (random access memory, RAM), and is used as an external cache. Through example but not limitative description, RAMs in many forms are available, such as a static random access memory (static RAM, SRAM), a dynamic random access memory (dynamic RAM, DRAM), a synchronous dynamic random access memory (synchronous DRAM, SDRAM), a double data rate synchronous dynamic random access memory (double data rate SDRAM, DDR SDRAM), an enhanced synchronous dynamic random access memory (enhanced SDRAM, ESDRAM), a synchlink dynamic random access memory (synchlink DRAM, SLDRAM), and a direct rambus random access memory (direct rambus RAM, DRRAM). It should be noted that the memory in the systems and methods described in this specification is intended to include but is not limited to these and any memory of another appropriate type.

Terms such as "unit" and "system" used in this specification indicate computer-related entities, hardware, firmware, combinations of hardware and software, software, or software being executed. For example, a component may be, but is not limited to, a process running on a processor, a processor, an object, an executable file, a thread of execution, a program, and/or a computer. As illustrated by using figures, both a computing device and an application that runs on the computing device may be components. One or more components may reside within a process and/or a thread of execution. The components may be located on one computer and/or distributed between two or more computers. In addition, these components may be executed from various computer-readable media that store various data structures. The components may communicate by using a local and/or remote process based on a signal having one or more data packets (for example, data from two components interacting with another component in a local system, a distributed system, and/or across a network such as the Internet interacting with another system by using the signal).

A person of ordinary skill in the art may be aware that, in combination with the examples described in embodiments disclosed in this specification, units and algorithm steps may be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that the implementation goes beyond the scope of this application.

It may be clearly understood by a person skilled in the art that, for the purpose of convenient and brief description, for a detailed working process of the foregoing system, apparatus, and unit, refer to a corresponding process in the foregoing method embodiments. Details are not described herein again.

In several embodiments provided in this application, it should be understood that the disclosed system, apparatus, and method may be implemented in another manner. For example, the described apparatus embodiment is merely an example. For example, division into the units is merely logical function division and may be other division in actual implementation. For example, a plurality of units or components may be combined or integrated into another system, or some features may be ignored or not performed. In addition, the displayed or discussed mutual couplings or direct couplings or communication connections may be implemented through some interfaces. The indirect couplings or communication connections between the apparatuses or units may be implemented in electrical, mechanical, or another form.

The units described as separate parts may or may not be physically separate, and parts displayed as units may or may not be physical units, may be located in one position, or may be distributed on a plurality of network units. Some or all of the units may be selected based on actual requirements to achieve the objectives of the solutions of embodiments.

In addition, functional units in embodiments of this application may be integrated into one processing unit, each of the units may exist alone physically, or two or more units may be integrated into one unit.

When the functions are implemented in the form of a software functional unit and sold or used as an independent product, the functions may be stored in a computer-readable storage medium. Based on such an understanding, the technical solutions of this application essentially, or the part contributing to the conventional technology, or some of the technical solutions may be implemented in a form of a software product. The computer software product is stored in a storage medium, and includes several instructions for instructing a computer device (which may be a personal computer, a server, or a network device) to perform all or some of the steps of the methods described in embodiments of this application. The foregoing storage medium includes any medium that can store program code, such as a USB flash drive, a removable hard disk, a read-only memory, a random access memory, a magnetic disk, or an optical disc.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

**Claims**

1.  A rate matching method, comprising:

    performing, by a transmit end, rate matching on a first low-density parity-check LDPC codeword with a first code rate based on a priority order of check bits of a mother code of an LDPC code, to obtain a second LDPC codeword with a second code rate, wherein the priority order indicates a priority order of puncturing the check bits of the mother code during rate matching, the priority order is related to confidences of the check bits, and the confidences of the check bits indicate degrees to which the check bits are affected by noise in a channel transmission process; and
    sending, by the transmit end, the second LDPC codeword.

2.  The method according to claim 1, wherein the performing, by a transmit end, rate matching on a first LDPC codeword with a first code rate based on a priority order of check bits of a mother code comprises:
    selecting, by the transmit end based on a quantity L of to-be-punctured bits and the priority order of the check bits of the mother code, L check bits in the first LDPC codeword for puncturing, wherein the priority order is a descending order of the confidences of the check bits, and the L check bits are the first L check bits in the priority order, wherein $L \geq 1$, and L is an integer.

3.  The method according to claim 1 or 2, wherein a check matrix of the mother code comprises a check part, the check part comprises a column that corresponds to a check bit and that is in the check matrix, and the priority order indicates a priority order of columns comprised in the check part, wherein each of the columns comprised in the check part corresponds to z check bits of the mother code, $z = N/n$, N is a code length of the mother code, and n represents a total quantity of columns comprised in the check matrix of the mother code.

4.  The method according to claim 3, wherein the code length of the mother code is 1944, a code rate is 1/2, the check part is a $13^{th}$ column to a $24^{th}$ column in the check matrix of the mother code, and a descending order of priorities of the $13^{th}$ column to the $24^{th}$ column is as follows:
    13, 14, 24, 15, 23, 16, 22, 17, 21, 18, 20, 19.

5.  The method according to claim 3, wherein the code length of the mother code is 1296, a code rate is 1/2, the check part is a $13^{th}$ column to a $24^{th}$ column in the check matrix of the mother code, and a descending order of priorities of the $13^{th}$ column to the $24^{th}$ column is as follows:
    13, 17, 22, 18, 24, 16, 23, 19, 14, 21, 15, 20.

6.  The method according to claim 3, wherein the code length of the mother code is 648, a code rate is 1/2, the check part is a $13^{th}$ column to a $24^{th}$ column in the check matrix of the mother code, and a descending order of priorities of the $13^{th}$ column to the $24^{th}$ column is as follows:
    13, 17, 16, 20, 24, 14, 19, 18, 23, 22, 15, 21.

7.  The method according to any one of claims 4 to 6, wherein priorities of z check bits corresponding to any column comprised in the check part are the same.

8.  The method according to claim 7, wherein the L check bits in the first LDPC codeword meet one of the following:

    if $L < z$, the L check bits in the first LDPC codeword are L check bits in z check bits corresponding to a highest-priority column in the columns comprised in the check part, wherein z is a positive integer; or
    if $L > z$, the L check bits in the first LDPC codeword are L check bits in tz check bits corresponding to t columns in the columns comprised in the check part, wherein the t columns are the first t columns in the columns comprised in the check part that are sorted in descending order of priorities, the L check bits comprise $z(t-1)$ check bits corresponding to the first t-1 columns in the t columns and p check bits in a $t^{th}$ column, the p check bits are any p check bits in z check bits corresponding to the $t^{th}$ column, both t and p are positive integers, and $p \leq z$; or

if L = mz, the L check bits in the first LDPC codeword are mz check bits corresponding to m columns in the columns comprised in the check part, wherein the m columns are the first m columns in the columns comprised in the check part that are sorted in descending order of priorities, $m \geq 1$, and m is an integer.

9. The method according to claim 8, wherein after the sending, by the transmit end, the second LDPC codeword, the method further comprises:

   receiving, by the transmit end, retransmission indication information;
   performing, by the transmit end, rate matching on a to-be-retransmitted codeword based on the priority order of the check bits of the mother code, to obtain a third LDPC codeword with a third code rate, wherein the to-be-retransmitted codeword is obtained by performing LDPC encoding on to-be-retransmitted bits, and a puncturing position set of check bits of the third LDPC codeword is a proper subset of a puncturing position set of check bits of the second LDPC codeword; and
   sending, by the transmit end, the third LDPC codeword.

10. A communication apparatus, comprising:

    a processing unit, configured to perform rate matching on a first low-density parity-check LDPC codeword with a first code rate based on a priority order of check bits of a mother code of an LDPC code, to obtain a second LDPC codeword with a second code rate, wherein the priority order indicates a priority order of puncturing the check bits of the mother code during rate matching, the priority order is related to confidences of the check bits, and the confidences of the check bits indicate degrees to which the check bits are affected by noise in a channel transmission process; and
    a transceiver unit, configured to send the second LDPC codeword.

11. The communication apparatus according to claim 10, wherein the processing unit is specifically configured to:
    select, for puncturing and based on a quantity L of to-be-punctured bits and the priority order of the check bits of the mother code, L check bits in the first LDPC codeword, wherein the priority order is a descending order of the confidences of the check bits, and the L check bits are the first L check bits in the priority order, wherein $L \geq 1$, and L is an integer.

12. The communication apparatus according to claim 10 or 11, wherein a check matrix of the mother code comprises a check part, the check part comprises a column that corresponds to a check bit and that is in the check matrix, and the priority order indicates a priority order of columns comprised in the check part, wherein each of the columns comprised in the check part corresponds to z check bits of the mother code, z = N/n, N is a code length of the mother code, and n represents a total quantity of columns comprised in the check matrix of the mother code.

13. The communication apparatus according to claim 12, wherein the code length of the mother code is 1944, a code rate is 1/2, the check part is a $13^{th}$ column to a $24^{th}$ column in the check matrix of the mother code, and a descending order of priorities of the $13^{th}$ column to the $24^{th}$ column is as follows:
    13, 14, 24, 15, 23, 16, 22, 17, 21, 18, 20, 19.

14. The communication apparatus according to claim 12, wherein the code length of the mother code is 1296, a code rate is 1/2, the check part is a $13^{th}$ column to a $24^{th}$ column in the check matrix of the mother code, and a descending order of priorities of the $13^{th}$ column to the $24^{th}$ column is as follows:
    13, 17, 22, 18, 24, 16, 23, 19, 14, 21, 15, 20.

15. The communication apparatus according to claim 12, wherein the code length of the mother code is 648, a code rate is 1/2, the check part is a $13^{th}$ column to a $24^{th}$ column in the check matrix of the mother code, and a descending order of priorities of the $13^{th}$ column to the $24^{th}$ column is as follows:
    13, 17, 16, 20, 24, 14, 19, 18, 23, 22, 15, 21.

16. The communication apparatus according to any one of claims 13 to 15, wherein priorities of z check bits corresponding to any column comprised in the check part are the same.

17. The communication apparatus according to claim 16, wherein the L check bits in the first LDPC codeword meet one of the following:

if $L < z$, the L check bits in the first LDPC codeword are L check bits in z check bits corresponding to a highest-priority column in the columns comprised in the check part, wherein z is a positive integer; or

if $L > z$, the L check bits in the first LDPC codeword are L check bits in tz check bits corresponding to t columns in the columns comprised in the check part, wherein the t columns are the first t columns in the columns comprised in the check part that are sorted in descending order of priorities, the L check bits comprise $z(t-1)$ check bits corresponding to the first t-1 columns in the t columns and p check bits in a $t^{th}$ column, the p check bits are any p check bits in z check bits corresponding to the $t^{th}$ column, both t and p are positive integers, and $p \leq z$; or

if $L = mz$, the L check bits in the first LDPC codeword are mz check bits corresponding to m columns comprised in the check part, wherein the m columns are the first m columns in the columns comprised in the check part that are sorted in descending order of priorities, $m \geq 1$, and m is an integer.

18. The communication apparatus according to claim 17, wherein the transceiver unit is further configured to receive retransmission indication information;

the processing unit is further configured to perform rate matching on a to-be-retransmitted codeword based on the priority order of the check bits of the mother code, to obtain a third LDPC codeword with a third code rate, wherein the to-be-retransmitted codeword is obtained by performing LDPC encoding on to-be-retransmitted bits, and a puncturing position set of check bits of the third LDPC codeword is a proper subset of a puncturing position set of check bits of the second LDPC codeword; and

the transceiver unit is further configured to send the third LDPC codeword.

19. A communication apparatus, comprising a processor and an interface circuit, wherein the interface circuit is configured to receive computer code or instructions, and transmit the computer code or the instructions to the processor, and when the processor runs the computer code or the instructions, the method according to any one of claims 1 to 9 is implemented.

20. A communication apparatus, comprising at least one processor, wherein the at least one processor is coupled to at least one memory, and the at least one processor is configured to execute a computer program or instructions stored in the at least one memory, to enable the communication apparatus to perform the method according to any one of claims 1 to 9.

21. A computer-readable storage medium, wherein the computer-readable storage medium stores computer instructions; and when the computer instructions are run on a computer, the method according to any one of claims 1 to 9 is implemented.

$$H = \begin{matrix} & V_1 & V_2 & V_3 & V_4 & V_5 & V_6 & V_7 & V_8 & \\ & 1 & 0 & 1 & 0 & 1 & 0 & 1 & 0 & \\ & 1 & 0 & 0 & 1 & 0 & 1 & 0 & 1 & \\ & 0 & 1 & 1 & 0 & 0 & 1 & 1 & 0 & \\ & 0 & 0 & 0 & 1 & 1 & 0 & 0 & 1 & \end{matrix} \begin{matrix} C_1 \\ C_2 \\ C_3 \\ C_4 \end{matrix}$$

FIG. 1

FIG. 2

(a)

(b)

FIG. 3

400

| Perform rate matching on a first LDPC codeword with a first code rate based on a priority order of check bits of a mother code of an LDPC code, to obtain a second LDPC codeword with a second code rate, where the priority order indicates a priority order of puncturing the check bits of the mother code during rate matching, the priority order is related to confidences of the check bits, and the confidences of the check bits indicate degrees to which the check bits are affected by noise in a channel transmission process |
|---|

410

| Send the second LDPC codeword |
|---|

420

FIG. 4

Priority order (confidence sorting list)

| $t_1$ | $t_2$ | ... | $t_k$ | ... |
|---|---|---|---|---|

Encode

| System bit | 0 | 1 | 2 | 3 | ... | $N_0-1$ |
|---|---|---|---|---|---|---|

Puncture (punch)

| System bit | 0 | 1 | 2 | 3 | ... | $N_i$ | ... | $N_p$ | ... | $N_0-1$ |
|---|---|---|---|---|---|---|---|---|---|---|

$t_2$       $t_1$    $t_k$

Send

| System bit | 0 | 2 | 3 | ... | $N_0-1$ |
|---|---|---|---|---|---|

FIG. 5

Priority order

| $t_1$ | $t_2$ | ... | $t_k$ | ... |
|---|---|---|---|---|

Receive

| System bit | 0 | 2 | 3 | ... | $N_0-1$ |
|---|---|---|---|---|---|

Process

| System bit | 0 | Pad with zeros | 2 | 3 | ... | Pad with zeros | ... | Pad with zeros | ... | $N_0-1$ |
|---|---|---|---|---|---|---|---|---|---|---|

$t_2$       $t_1$    $t_k$

Decode

FIG. 6

```
            ┌──────────────────┐
            │      Start       │
            └──────────────────┘
                     │
                     ▼
            ┌──────────────────┐
            │ Fixed source σ=0 │
            └──────────────────┘
                     │
                     ▼
            ┌──────────────────┐
            │ LDPC encoding and│
            │  BPSK modulation │
            └──────────────────┘
                     │
                     ▼
                 ◇ Modulation
               information = 1?
```

Yes          No

Decoding initial information is x     Decoding initial information is –x

Iterative decoding

Quantity of iterations ≥ n?

Yes          No

Output LLRs, and collect statistics on and sort absolute values of the LLRs, to obtain a confidence order

FIG. 7

FIG. 8

600

| Transmit end | | Receive end |

601: Perform LDPC encoding on k information bits based on a required code rate R and code length N, to obtain a first LDPC codeword

602: Perform rate matching on the first LDPC codeword based on a priority order of check bits of a mother code, to obtain a second LDPC codeword

603: Second LDPC codeword
(with a second code rate)

604: Pad, with zeros based on the priority order of an LDPC code, corresponding positions of a first LLR sequence corresponding to a first channel receiving sequence, and then decode the first LLR sequence that is padded with zeros

605: When successfully decoding system bits, output a decoding result

606: Retransmission indication information

607: Third LDPC codeword
(with a third code rate)

608: Pad, with zeros based on the priority order of the LDPC code, corresponding positions of a second LLR sequence corresponding to a second channel receiving sequence, and then decode a combined sequence of the second LLR sequence that is padded with zeros and the first LLR sequence that is padded with zeros

609: When successfully decoding system bits, output a decoding result

610: Continue retransmission until a maximum quantity of retransmissions is reached, or until decoding fails

FIG. 9

FIG. 10

FIG. 11

Legend:
- puncturing reliable bits (2)
- puncturing unreliable bits (2)
- 802.11ac puncturing (2)
- puncturing reliable bits (4)
- puncturing unreliable bits (4)
- 802.11ac puncturing (4)
- puncturing reliable bits (6)
- puncturing unreliable bits (6)
- 802.11ac puncturing (6)
- puncturing reliable bits (8)
- puncturing unreliable bits (8)
- 802.11ac puncturing (8)
- puncturing reliable bits (9)
- puncturing unreliable bits (9)
- 802.11ac puncturing (9)

Axes: FER versus $E_b/N_0$

FIG. 12

EP 4 568 149 A1

| | First transmission | Second transmission | Third transmission | Fourth transmission |
|---|---|---|---|---|
| Confidence-based RCPL-HARQ technology | Punctured QC-LDPC code | 21 | 17, 22 | 16, 23, 15, 24, 14, 13 |
| RCPL-HARQ technology based on puncturing unreliable bits | Punctured QC-LDPC code | 15 | 23, 16 | 22, 17, 21, 18, 20, 19 |
| RCPL-HARQ technology based on the 802.11ac standard | Punctured QC-LDPC code | 16 | 18, 17 | 24, 23, 22, 21, 20, 19 |
| Valid code rate | 0.8 | 0.75 | 0.67 | 1/2 |

FIG. 13

EP 4 568 149 A1

| | First transmission | Second transmission | Third transmission | Fourth transmission |
|---|---|---|---|---|
| Confidence-based RCPL-HARQ technology | Punctured QC-LDPC code | 15, 22 | 14, 23 | 12, 13 |
| RCPL-HARQ technology based on puncturing unreliable bits | Punctured QC-LDPC code | 17, 22 | 18, 21 | 19, 20 |
| RCPL-HARQ technology based on the 802.11ac standard | Punctured QC-LDPC code | 20, 19 | 22, 21 | 24, 23 |
| Valid code rate | 0.67 | 0.6 | 0.55 | 1/2 |

FIG. 14

| | First transmission | Second transmission | Third transmission |
|---|---|---|---|
| Confidence-based RCPL-HARQ technology | Punctured QC-LDPC code | 17, 22, 16, 23 | 15, 24, 14, 13 |
| RCPL-HARQ technology based on puncturing unreliable bits | Punctured QC-LDPC code | 17, 22, 16, 23 | 19, 20, 18, 21 |
| RCPL-HARQ technology based on the 802.11ac standard | Punctured QC-LDPC code | 20, 19, 18, 17 | 24, 23, 22, 21 |
| Valid code rate | 0.75 | 0.6 | 0.5 |

FIG. 15

EP 4 568 149 A1

| | First transmission | Second transmission | Third transmission |
|---|---|---|---|
| Confidence-based RCPL-HARQ technology | Punctured QC-LDPC code | 16, 23, 15 | 24, 14, 13 |
| RCPL-HARQ technology based on puncturing unreliable bits | Punctured QC-LDPC code | 21, 17, 22 | 19, 20, 18 |
| RCPL-HARQ technology based on the 802.11ac standard | Punctured QC-LDPC code | 21, 20, 19 | 24, 23, 22 |
| Valid code rate | 0.67 | 0.57 | 0.5 |

EP 4 568 149 A1

FIG. 16

|  | First transmission | Second transmission |
|---|---|---|
| Confidence-based RCPL-HARQ technology | Punctured QC-LDPC code | 13, 14, 24, 15, 23, 16, 22, 17, 21 |
| RCPL-HARQ technology based on puncturing unreliable bits | Punctured QC-LDPC code | 19, 20, 18, 21, 17, 22, 16, 23, 15 |
| RCPL-HARQ technology based on the 802.11ac standard | Punctured QC-LDPC code | 24, 23, 22, 21, 20, 19, 18, 17, 16 |
| Valid code rate | 0.8 | 0.5 |

FIG. 17

|  | First transmission | Second transmission |
|---|---|---|
| Confidence-based RCPL-HARQ technology | Punctured QC-LDPC code | 13, 14, 24, 15, 23, 16, 22, 17 |
| RCPL-HARQ technology based on puncturing unreliable bits | Punctured QC-LDPC code | 19, 20, 18, 21, 17, 22, 16, 23 |
| RCPL-HARQ technology based on the 802.11ac standard | Punctured QC-LDPC code | 24, 23, 22, 21, 20, 19, 18, 17 |
| Valid code rate | 0.75 | 0.5 |

FIG. 18

EP 4 568 149 A1

|  | First transmission | Second transmission |
|---|---|---|
| Confidence-based RCPL-HARQ technology | Punctured QC-LDPC code | 13, 14, 24, 15, 23, 16 |
| RCPL-HARQ technology based on puncturing unreliable bits | Punctured QC-LDPC code | 19, 20, 18, 21, 17, 22 |
| RCPL-HARQ technology based on the 802.11ac standard | Punctured QC-LDPC code | 24, 23, 22, 21, 20, 19 |
| Valid code rate | 0.67 | 0.5 |

FIG. 19

Communication
apparatus 1000

Processing unit 1100

Receiving unit 1200

Sending unit 1300

FIG. 20

Communication apparatus 10

Processor
11

Memory
12

Communication
interface
13

FIG. 21

## INTERNATIONAL SEARCH REPORT

| International application No. |
| --- |
| **PCT/CN2023/104371** |

**A. CLASSIFICATION OF SUBJECT MATTER**

H04L1/00(2006.01)i

According to International Patent Classification (IPC) or to both national classification and IPC

**B. FIELDS SEARCHED**

Minimum documentation searched (classification system followed by classification symbols)

IPC: H04L

Documentation searched other than minimum documentation to the extent that such documents are included in the fields searched

Electronic data base consulted during the international search (name of data base and, where practicable, search terms used)

CNTXT; VEN; CNABS; USTXT; CNKI: 打孔, 可靠度, 可靠性, 速率, 匹配, 校验比特, 优先级, 置信度, LDPC, punching, priority

**C. DOCUMENTS CONSIDERED TO BE RELEVANT**

| Category* | Citation of document, with indication, where appropriate, of the relevant passages | Relevant to claim No. |
| --- | --- | --- |
| X | CN 113395132 A (HUAWEI TECHNOLOGIES CO., LTD.) 14 September 2021 (2021-09-14) description, paragraphs [0056]-[0066] and [0110]-[0390], and claims 1-21 | 1-21 |
| X | CN 113708778 A (HUAWEI TECHNOLOGIES CO., LTD.) 26 November 2021 (2021-11-26) description, paragraphs [0097]-[0450] | 1-21 |
| X | 张勇(ZHANG, Yong). "自适应LDPC编译码技术研究 (Non-official translation: Research on Adaptive LDPC Coding and Decoding Technology)" 中国优秀硕士学位论文全文数据库信息科技辑 (Non-official translation: Information & Technology, China Master's Theses Full-Text Database), 15 July 2017 (2017-07-15), text, chapters 3 and 4 | 1-21 |
| A | CN 105490684 A (HUAQIAO UNIVERSITY) 13 April 2016 (2016-04-13) entire document | 1-21 |
| A | CN 106656409 A (HUAWEI TECHNOLOGIES CO., LTD.) 10 May 2017 (2017-05-10) entire document | 1-21 |

☐ Further documents are listed in the continuation of Box C.      ☑ See patent family annex.

| | |
| --- | --- |
| \* Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
| --- | --- |
| **12 September 2023** | **28 September 2023** |

| Name and mailing address of the ISA/CN | Authorized officer |
| --- | --- |
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2023/104371**

| Patent document cited in search report | | | Publication date (day/month/year) | Patent family member(s) | Publication date (day/month/year) |
|---|---|---|---|---|---|
| CN | 113395132 | A | 14 September 2021 | None | |
| CN | 113708778 | A | 26 November 2021 | None | |
| CN | 105490684 | A | 13 April 2016 | None | |
| CN | 106656409 | A | 10 May 2017 | None | |

Form PCT/ISA/210 (patent family annex) (July 2022)

**EP 4 568 149 A1**

**Patent documents cited in the description**

- CN 202211026138X